(19) **Europäisches Patentamt / European Patent Office / Office européen des brevets**

(11) **EP 4 333 253 A1**

(12) # EUROPEAN PATENT APPLICATION
published in accordance with Art. 153(4) EPC

(43) Date of publication:
06.03.2024 Bulletin 2024/10

(21) Application number: 22848955.5

(22) Date of filing: 31.03.2022

(51) International Patent Classification (IPC):
H02J 7/10 (2006.01)        H01M 10/48 (2006.01)

(52) Cooperative Patent Classification (CPC):
H01M 10/48; H02J 7/06; Y02E 60/10

(86) International application number:
PCT/JP2022/016965

(87) International publication number:
WO 2023/007872 (02.02.2023 Gazette 2023/05)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 27.07.2021 JP 2021122758

(71) Applicant: Vehicle Energy Japan Inc.
Ibaraki 312-8505 (JP)

(72) Inventor: AKATSU, Miyuki
Hitachinaka-shi, Ibaraki 312-8505 (JP)

(74) Representative: Manitz Finsterwald
Patent- und Rechtsanwaltspartnerschaft mbB
Martin-Greif-Strasse 1
80336 München (DE)

(54) **BATTERY CONTROL METHOD**

(57) By using a control unit that controls a battery, a storage unit that stores data of allowable electric power, and a measurement unit that measures a voltage value between a pair of electrode terminals of the battery, the allowable electric power is defined as chargeable maximum electric power which is calculated based on a predetermined upper limit voltage value and a current charged state; wherein the data includes: a first voltage value that is an upper limit value for which a limitation of the allowable electric power is not required; a second voltage value which is higher than the first voltage value and for which a partial limitation of the allowable electric power is required; and a third voltage value which is higher than the second voltage value and for which a complete limitation of the allowable electric power is required; and wherein the control unit: acquires the voltage value from the measurement unit at every specified time; performs the complete limitation of the allowable electric power when the voltage value of the allowable electric power becomes equal to or higher than the third voltage value; and performs the partial limitation or the complete limitation of the allowable electric power while the voltage value of the allowable electric power decreases to the second voltage value and then to the first voltage value. Accordingly, a battery control method which eliminates hunting and enhances reliability is provided.

FIG. 10

**Description**

TECHNICAL FIELD

The present invention relates to a battery control method.

BACKGROUND ART

Regarding a vehicle system for giving/receiving electric power to/from a secondary battery system mounted in a vehicle, there is "allowable electric power" as an index indicating maximum electric power which can be output from a battery, and maximum electric power which can be consumed by the vehicle system. The vehicle system is operated by a battery control method for keeping power consumption within the range of the allowable electric power or less. Also, there are two kinds of the allowable electric power: the allowable electric power in an electric charging direction (allowable electric charging power); and the allowable electric power in an electric discharge direction (allowable electric discharge power).

For example, the allowable electric discharge power is decided by referring to the difference between a minimum working voltage and a current battery voltage. However, if an anomaly has occurred at the battery system even within the range of the allowable electric discharge power, the allowable electric power is forcedly limited and the use of the battery by the vehicle system is limited in order to immediately prohibit or suppress electric charging/discharging of the battery.

PTL 1 discloses a mechanism for preventing overcharge and overdischarge during the electric charging/discharging. That mechanism is provided as a function that performs post-processing of an electric power value which is computed to limit the allowable electric power; and an overvoltage threshold voltage and an overdischarge threshold voltage are set and an arithmetic operation value of the allowable electric power is limited with a rate before reaching that battery voltage. The post-processing is as follows. At a limitation start threshold voltage, a limitation rate is set as 100% and the voltage is output as it is. Moreover, at a limitation end threshold voltage, the limitation rate is set as 0% and a computing result is 0W. Furthermore, the limitation rate is applied according to a constant slope between the threshold voltages.

CITATION LIST

PATENT LITERATURE

PTL 1:WO 2012/157065

SUMMARY OF THE INVENTION

PROBLEMS TO BE SOLVED BY THE INVENTION

However, with the mechanism of PTL 1, as the allowable electric power comes close to an unstable state such as overcharge or overdischarge, it temporarily achieves a safe state by limiting the allowable electric power; however, there is fear that the allowable electric power may become unstable immediately after that. That mechanism has such disadvantages that along with up-and-down fluctuations of an output voltage in short cycles, hunting which repeats limitations on the allowable electric power and their cancellations in short cycles occurs and the output of the allowable electric power becomes unstable.

The present invention was devised in light of the above-described problems and it is an object of the invention to provide a battery control method which eliminates the hunting causing the limitations on the allowable electric power and their cancellations and enhances reliability.

MEANS TO SOLVE THE PROBLEMS

A battery control method according to the present invention uses: a control unit that controls a battery; a storage unit that stores data regarding allowable electric power for charging the battery; and a measurement unit that measures a voltage value between a pair of electrode terminals of the battery, wherein the allowable electric power is defined as chargeable maximum electric power which is calculated based on a predetermined upper limit voltage value and a current charged state; wherein the data includes: a first voltage value that is an upper limit value for which a limitation of the allowable electric power is not required; a second voltage value which is higher than the first voltage value and for which a partial limitation of the allowable electric power is required; and a third voltage value which is higher than the second voltage value and for which a complete limitation of the allowable electric power is required; and wherein the control unit: acquires the voltage value from the measurement unit at every specified time; performs the complete limitation of the allowable electric power when the voltage value of the allowable electric power becomes equal to or higher than the third voltage value; and performs the partial limitation or the complete limitation of the allowable electric power while the voltage value of the allowable electric power decreases to the second voltage value and then to the first voltage value.

ADVANTAGEOUS EFFECTS OF THE INVENTION

The battery control method which eliminates the hunting causing the limitations on the allowable electric power and their cancellations and enhances the reliability can be provided according to the present invention.

BRIEF DESCRIPTION OF DRAWINGS

Fig. 1 is a block diagram illustrating the configuration of a battery system according to Embodiment 1 (hereinafter also referred to as "this system");
Fig. 2 is a block diagram illustrating the further details of a battery status estimation unit for this system in Fig. 1;
Fig. 3 is a block diagram illustrating the further details of an allowable electric power computing unit included in the battery status estimation unit in Fig. 2;
Fig. 4 is an equivalent circuit diagram illustrating a battery model used for this system explained with reference to Fig. 1 to Fig. 3;
Fig. 5 is a block diagram illustrating the further details of an allowable electric power limitation unit in this system in Fig. 1 ;
Fig. 6 is a graph illustrating an allowable electric charging power limiting method according to a comparative example (hereinafter also referred to as an "electric charging limitation method of the comparative example" or "battery control method");
Fig. 7 is a graph illustrating a hunting phenomenon which occurs due to the electric charging limitation method according to the comparative example illustrated in Fig. 6;
Fig. 8 is a graph illustrating an allowable electric discharge power limiting method according to a comparative example (hereinafter also referred to as an "electric discharge limitation method according to the comparative example" or "battery control method");
Fig. 9 is a graph illustrating a hunting phenomenon which occurs due to the electric discharge limitation method according to the comparative example illustrated in Fig. 8;
Fig. 10 is a graph illustrating an allowable electric charging power limiting method for this system in Fig. 1 (hereinafter also referred to as "this electric charging limitation method" or "battery control method");
Fig. 11 is a flowchart illustrating processing from a limitation occurrence to a limitation cancellation in this electric charging limitation method in Fig. 10;
Fig. 12 is a graph illustrating application effects of this electric charging limitation method in Fig. 10 and Fig. 11;
Fig. 13 is a graph illustrating an allowable electric discharge power limiting method for this system in Fig. 1 (hereinafter also referred to as "this electric discharge limitation method" or "battery control method");
Fig. 14 is a flowchart illustrating processing from a limitation occurrence to a limitation cancellation in this electric discharge limitation method in Fig. 13;
Fig. 15 is a graph illustrating application effects of this electric discharge limitation method in Fig. 13 and Fig. 14;
Fig. 16 is a graph illustrating an allowable electric charging power limiting method according to Embodiment 2 (hereinafter also referred to as "this electric charging limitation method according to Embodiment 2" or "battery control method");
Fig. 17 is a graph illustrating an allowable electric discharge power limiting method according to Embodiment 2 (hereinafter also referred to as "this electric discharge limitation method according to Embodiment 2" or "battery control method");
Fig. 18 is a block diagram illustrating an allowable electric power limitation unit (see Fig. 3) according to Embodiment 3;
Fig. 19 is a graph illustrating an allowable electric charging power limiting method using the allowable electric power limitation unit in Fig. 18 (hereinafter also referred to as "this electric charging limitation method according to Embodiment 3" or "battery control method"); and
Fig. 20 is a graph illustrating an allowable electric charging power limiting method using the allowable electric power limitation unit in Fig. 18 (hereinafter also referred to as "this electric discharge limitation method according to Embodiment 3" or "battery control method").

DESCRIPTION OF EMBODIMENTS

Embodiments for implementing the present invention will be described below with reference to the drawings.

[Embodiment 1]

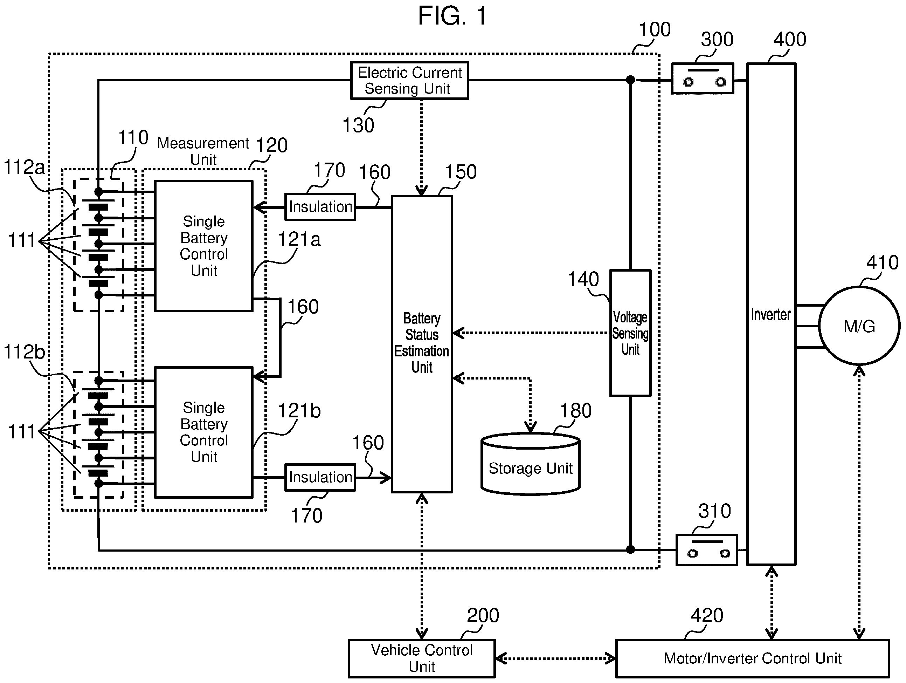

Fig. 1 is a block diagram illustrating the configuration of a battery system (this system) 100 according to Embodiment 1. The battery system 100 is a system for supplying electric power to an external supply object(s) and electric automobiles, hybrid automobiles, trains, industrial equipment, and so on are assumed as the supply objects. A hybrid automobile is equipped with the battery system 100 in Fig. 1, which is configured to give/receive the electric power to/from a motor generator 410 for traveling.

The battery system 100 is connected to an inverter 400 via relays 300, 310. The inverter 400 supplies the electric power from the battery system 100 to the motor generator 410. The inverter 400 and the motor generator 410 are controlled by a motor/inverter control unit 420. A vehicle control unit 200 decides, for example, allocations of a driving force based on battery information obtained from the battery system 100, information from the inverter 400 and the motor generator 410, and information from, for example, an engine which is not illustrated in the drawing.

The battery system 100 includes: an assembled battery 110 configured from a plurality of single batteries 111; a measurement unit 120 which includes a plurality of single battery control units 121a, 121b (collectively 121) for monitoring the statuses of the single batteries 111; an electric current sensing unit 130 that senses an electric current which flows through the assembled battery 110; a voltage sensing unit 140 that senses a total voltage of the assembled battery 110; a battery status estimation unit 150 that estimates a battery status of the assembled battery 110; and a storage unit 180 that stores information about battery characteristics of the assembled battery 110, the single batteries 111, and single battery groups 112.

The plurality of single batteries 111 which constitute the assembled battery 110 are grouped into a specified number of units. As illustrated in Fig. 1, the plurality of single batteries 111 are divided into two single battery groups 112a, 112b. The single battery groups 112a, 112b are connected electrically serially.

Incidentally, the single batteries 111 are repeatedly chargeable batteries such as lithium-ion secondary batteries. Storage batteries such as nickel-hydrogen batteries, lead batteries, and electric double layer capacitors, and devices equipped with an electricity storage function are assumed as other examples of the single batteries 111. Here, one-cell batteries are assumed as the single batteries 111; however, it may be possible to adopt a configuration in which the plurality of single batteries 111 is replaced with module structures which are serially and parallelly connected.

Moreover, Fig. 1 illustrates the configuration as the assembled battery 110 in which the two single battery groups 112a, 112b are connected serially; however, there is no limitation to this example. The assembled battery 110 may be configured by connecting a specified number of single battery groups serially or by connecting them parallelly. Furthermore, the assembled battery 110 may be configured by various numbers of serial or parallel combinations depending on the intended use.

The measurement unit 120 monitors the status of each of the single batteries 11, which constitute the assembled battery 110, and is provided with the same number of single battery control units 121a, 121b as that of the plurality of single battery groups 112a, 112b corresponding to the plurality of single battery groups 112a, 112b. The single battery control unit 121a is allocated to the single battery group 112a and the single battery control unit 121b is allocated to the single battery group 112b.

Each single battery control unit 121a, 121b operates by receiving the electric power from the single battery group 112a, 112b which is allocated to it. Each single battery control unit 121a, 121b monitors a battery voltage and a battery temperature of the single battery group 112a, 112b which is allocated to it.

An electric current value of the electric current flowing through the assembled battery 110, which is transmitted from the electric current sensing unit 130, and a total voltage value of the assembled battery 110, which is transmitted from the voltage sensing unit 140, are input to the battery status estimation unit 150. Moreover, the battery status estimation unit 150 causes a signal communication unit 160 to send/receive signals to/from the measurement unit 120. This battery status estimation unit 150 receives diagnosis results and an anomaly signal from the measurement unit 120.

The diagnosis results mean battery voltages and battery temperatures of the single batteries 111 and also detected values of the measurement unit 12 regarding whether the single batteries 111 are overcharged or overdischarged, and diagnosis results based on those values. The anomaly signal is a signal which is output when a communication error has occurred at the measurement unit 120.

The battery status estimation unit 150 performs processing for, for example, estimating the battery status based on the input information. That processing result is transmitted to the measurement unit 120 and the vehicle control unit 200. The battery status estimation unit 150 performs numerical value computing processing for estimating the status of SOC, SOH, the allowable electric power, etc. Moreover, the measurement unit 120 operates by receiving the supply of the electric power from the assembled battery 110. On the other hand, the battery status estimation unit 150 uses a battery for an in-vehicle auxiliary machine (for example, a12V-type battery) as a power source.

Therefore, the battery status estimation unit 150, the measurement unit 120, and their respective operation power sources have different reference potentials. So, the signal communication unit 160 is provided with an insulation element 170 such as a photocoupler. The insulation element 170 may be mounted in a circuit board which configures the measurement unit 120, or may be mounted in a circuit board which configures the battery status estimation unit 150. Incidentally, the insulation element 170 can be omitted, depending on the system configuration.

The single battery control units 121a, 121b are connected serially in descending order of the potentials of the single battery groups 112a, 112b which they respectively monitor. The insulation element 170 is not provided between the output of the single battery control unit 121a and the input of the single battery control unit 121b. This is because the single battery control units 121a, 121b are provided with a mechanism capable of communications even between those having different operation reference potentials. However, if any electric insulation is required for the communication between the single battery control unit 121a and the single battery control unit 121b, the insulation element 170 needs to be provided.

A signal transmitted from the battery status estimation unit 150 is input by the signal communication unit 160, which is provided with the insulation element 170, to the single battery control unit 121a. An output signal from the single battery control unit 121b is transmitted by the signal communication unit 160, which is provided with the insulation element 170, to an input unit for the battery status estimation unit 150.

Accordingly, the battery status estimation unit 150 and the single battery control units 121a, 121b are connected by the signal communication unit 160 in a loop form. Such connection and communication system is called a daisy chain connection, but may be also called, for example, a bunching connection or a potato-vine connection.

The storage unit 180 stores information such as an OCV-SOC map. The OCV-SOC map is internal resistance property, capacity upon full charge, polarization resistance property, degradation property, individual difference information, and information indicating the correspondence relationship between an open circuit voltage OCV of the relevant battery and the state of charge SOC of the battery regarding the assembled battery 110, the single batteries 111, and the single battery groups 112.

Incidentally, in the example illustrated in Fig. 1, the storage unit 180 is a configuration placed outside the battery status estimation unit 150 and the measurement unit 120, but the storage unit 180 may be a configuration provided in the battery status estimation unit 150 or the measurement unit 120.

<Configuration of Battery Status Estimation Unit 150>

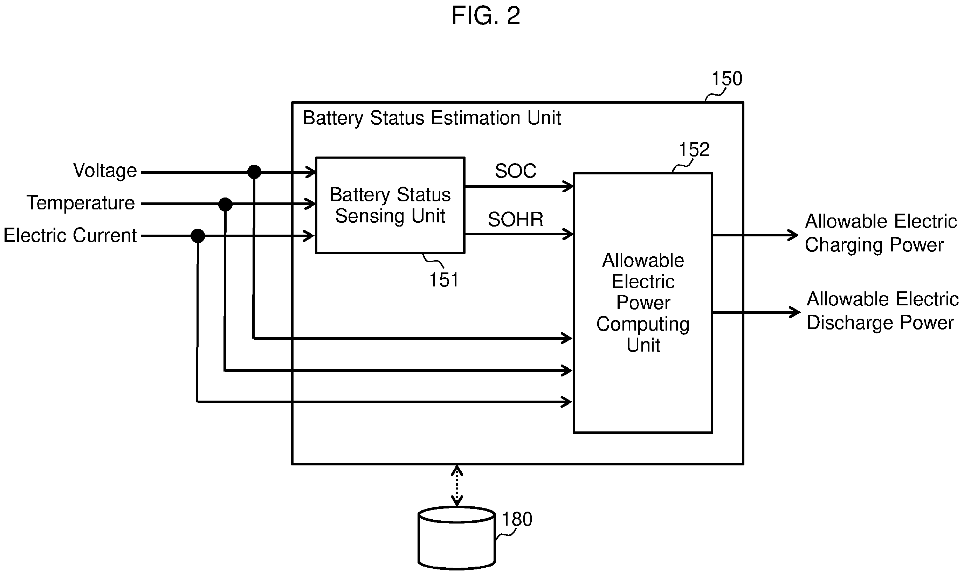

Fig. 2 is a block diagram illustrating the further details of the battery status estimation unit in this system 100 in Fig. 1. The battery status estimation unit 150 includes a battery status sensing unit 151 and an allowable electric power computing unit 152 as illustrated in Fig. 2. The battery status sensing unit 151 receives voltages, electric currents, and temperatures as inputs and computes and outputs the SOC (the state of charge of the battery) and the SOHR (the degradation rate of the battery).

The allowable electric power computing unit 152 receives the SOC and SOHR (similar concept as that of SOH), and the voltages, the electric currents, and the temperatures, as inputs which are the outputs of the battery status sensing unit 151, and computes and outputs the allowable electric charging power (a surplus electric power value until the voltage reaches an upper-limit chargeable voltage upon the electric charging) and the allowable electric discharge power (a surplus electric power value until the voltage reaches a lower-limit dischargeable voltage upon the electric discharge).

Under this circumstance, the voltages, the electric currents, and the temperatures which are input to the battery status sensing unit 151 and the allowable electric power computing unit 152 are representative values indicating the battery status of the assembled battery 110 which are obtained from the single battery control units 121a, 121b and the electric current sensing unit 130.

The voltages indicate information of variations and averages such as a maximum voltage, an average voltage, and the lowest voltage among the respective battery voltages of the single batteries 111. The electric currents indicate an instant electric current obtained at the same timing as the timing to obtain the battery voltage and a slot average electric current obtained by continuously sampling the electric current flowing through the assembled battery 110 in a certain time slot and calculating an average of a plurality of sampled electric current values.

Furthermore, the temperatures indicate the highest temperature, an average temperature, the lowest temperature which are obtained by a plurality of temperature sensors located within the assembled battery 110 in consideration of temperature distribution of the assembled battery 110 or the single battery groups 112 and the single batteries 111. These pieces of temperature information, the voltage values, and the electric current values are used as necessary in order to calculate the SOC, the SOHR, and the allowable electric power (the allowable electric charging power and the allowable electric discharge power).

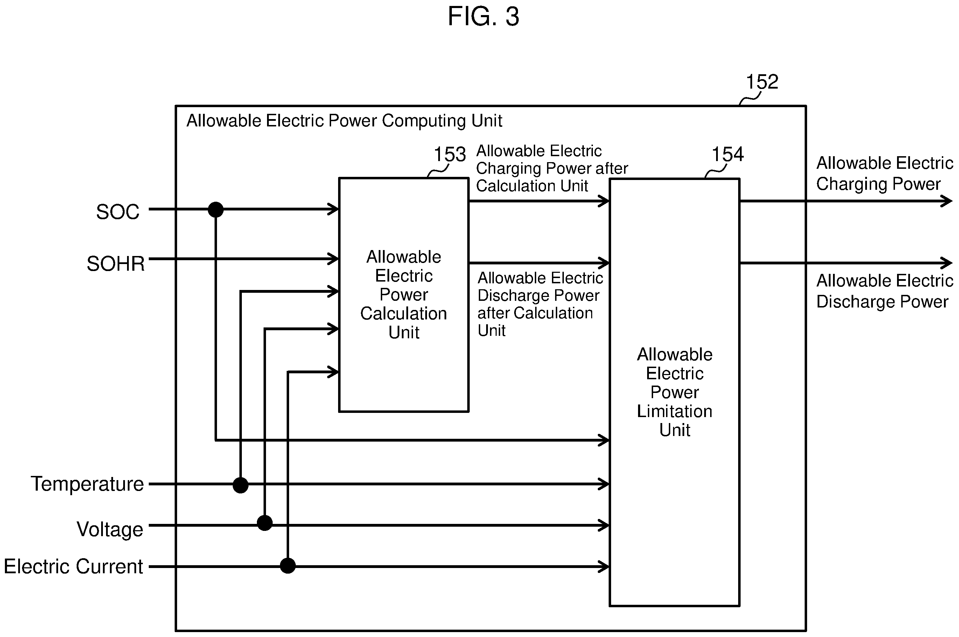

Fig. 3 is a block diagram illustrating the further details of the allowable electric power computing unit included in the battery status estimation unit in Fig. 2. The allowable electric power computing unit 152 is configured, as illustrated in Fig. 3, by including an allowable electric power calculation unit 153 and an allowable electric power limitation unit 154. The allowable electric power calculation unit 153 receives, as inputs, the SOC and the SOHR as well as the voltages, the electric currents, and the temperatures which are explained with reference to Fig. 2, and calculates the allowable electric power by including an index value of battery degradation.

The allowable electric power limitation unit 154 limits the allowable electric power as appropriate based on battery status information with respect to the allowable electric power which is output from the allowable electric power calculation unit 153. When this happens, the allowable electric power limitation unit 154 judges whether to limit the current allowable electric power or not by using the voltages, the electric currents, the temperatures, and the SOC as the battery status information.

Under this circumstance, final allowable electric power of the allowable electric power limitation unit 154 and the allowable electric power before the limitation by the allowable electric power calculation unit 153 will be distinguished from each other and called differently. The allowable electric charging power which is output from the allowable electric power calculation unit 153 will be referred to as the "allowable electric charging power after the calculation unit." The allowable electric discharge power which is output from the allowable electric power calculation unit 153 will be referred to as the "allowable electric discharge power after the calculation unit."

<Regarding Method for Calculating Allowable Electric Power>

In Embodiment 1, the allowable electric power calculation unit 153 estimates the allowable electric power by using an equivalent circuit model of a battery (hereinafter also referred to as a "battery model" or a "circuit model") from actual battery information (such as the SOC, the voltages, the temperatures, and the electric currents). Under this circumstance, an explanation will be provided about a method for calculating the allowable electric power by using the circuit model.

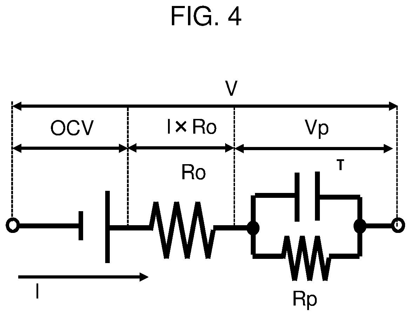

Fig. 4 is an equivalent circuit diagram illustrating the battery model used by this system 100 explained with reference to Fig. 1 to Fig. 3. The circuit model can be expressed, as illustrated in Fig. 4, as a circuit which serially connects a battery open circuit voltage OCV, current resistance Ro, polarization resistance Rp, and a CR parallel circuit (time constant τ) of a polarization capacity component.

The battery voltage V can be expressed as Expression (1) when an electric current I flows. A polarization voltage Vp in Expression (1) is a voltage which occurs when the electric current I flows through the polarization resistance Rp and the CR parallel circuit (with the time constant τ) of the polarization capacity component.

[Math. 1]

$$V = OCV + I \times Ro + Vp \ \dots \ \text{Expression (1)}$$

Firstly, an explanation will be provided about a method for calculating the allowable electric charging power according to Embodiment 1. The allowable electric charging power per battery is expressed as a product of an allowable electric charging current (Imax, chg) and a chargeable voltage (Vmax, chg). Under this circumstance, the allowable electric charging current (chargeable electric current) is a maximum electric current which may be made to flow in the current battery status.

Furthermore, the chargeable voltage is a voltage which occurs when the allowable electric charging current flows through the circuit model. The assembled battery 110 according to Embodiment 1 is configured with N pieces of the single batteries 111 which are connected serially. Therefore, the allowable electric discharge power according to Embodiment 1 is N times as large as the allowable electric charging power per battery multiplied by the number of the batteries.

Firstly, the allowable electric charging current Imax, chg is calculated. Expression (2) indicates a calculation expression which is the basic of the allowable electric charging current. The chargeable electric current is represented by Ichg here. The chargeable electric current is an electric current which flows when the voltage V indicated in the circuit model in Fig. 4 is equal to an upper limit voltage Vmax used by the vehicle system. Therefore, Expression (2) is obtained by transforming Expression (1) with respect to the electric current I.

However, in Embodiment 1, the open circuit voltage OCV is calculated by computation from the current SOC and the temperature T by using an OCV map indicating the correspondence relationship between the SOC and the battery temperature. Furthermore, the direct-current resistance Ro is also calculated from the current SOC and the temperature T by using an Ro map obtained from the correspondence relationship between the SOC and the temperature T. This Ro map is composed of values of a new battery and is different from a case where the battery has degraded. If that Ro is multiplied by the SOHR which is the degradation rate of the battery, the obtained result will come close to the actual Ro of the battery in consideration of the current degraded state of the battery.

[Math. 2]

$$I_{chg} = \frac{Vmax - (OCV(SOC,T) + Vp)}{Ro(SOC,T) \times \dfrac{SOHR}{100}} \quad \text{... Expression (2)}$$

The chargeable electric current Ichg obtained in Expression (2) is the maximum electric current which can be made to flow through the battery. However, the electric current which is equal to or more than an upper limit electric current Ilimit as specified by the specifications of the battery system 100 is limited even if the battery performance has some margin.

Expression (3) is an expression to represent the chargeable electric current Imax, chg which is obtained by restricting the upper limit electric current Ilimit of the system as the maximum electric current. The limitation is imposed on Ichg, which is obtained from the circuit model, so that it will not become equal to or more than the upper limit electric current Ilimit of the system. Accordingly, the maximum allowable electric current Imax, chg can be obtained.

[Math. 3]

$$I_{max,chg} = \min(I_{chg}, Ilimit) \quad \text{... Expression (3)}$$

Expression (4) is an expression to represent a chargeable voltage Vmax, chg. It is the voltage V when the allowable electric charging current Imax, chg is made to flow through the circuit model in Fig. 4 and is calculated by applying it to Expression (1). Similarly to Imax, chg, the OCV is calculated by using the OCV map. Furthermore, the current battery degradation is reflected in the Ro, which is calculated from the Ro map of a new battery, and the obtained result is multiplied by the degradation rate SOHR of the battery in order to make it closer to the actual Ro.

[Math. 4]

$$V_{max,chg} = OCV(SOC,T) + I_{max,chg} \times R_0(SOC,T) \times \frac{SOHR}{100} + Vp \quad \text{... Expression (4)}$$

The allowable electric power per battery is obtained by a product of the chargeable voltage Vmax, chg and the allowable electric charging current Imax, chg which are obtained above. In consideration of the fact that this exists for N pieces of batteries of the assembled battery 110, the allowable electric charging power after the calculation unit Wchg which is the output from the allowable electric power calculation unit 153 in Embodiment 1 is obtained in accordance with Expression (5).

[Math. 5]

$$W_{chg} = I_{max,chg} \times V_{max,chg} \times N \quad \text{... Expression (5)}$$

Next, an explanation will be provided about a method for calculating the allowable electric discharge power according to Embodiment 1. The allowable electric discharge power per battery is expressed as a product of the allowable electric charging current (Imax, dis) and a dischargeable voltage (Vmax, dis). Under this circumstance, the allowable electric discharge current (dischargeable electric current) is the maximum electric current which may be made to flow in the current battery status.

Furthermore, the dischargeable voltage is a voltage which is generated when the allowable electric discharge current is made to flow through the circuit model. The assembled battery 110 according to Embodiment 1 is configured with N pieces of the single batteries 111 which are connected serially. Therefore, the allowable electric discharge power according to Embodiment 1 is N times as large as the allowable electric discharge power per battery multiplied by the number of the batteries.

Firstly, the allowable electric discharge current Imax, dis is calculated. Expression (6) indicates a calculation expression which is the basic of the allowable electric discharge current. The dischargeable electric current is represented by Idis here. The dischargeable electric current can be calculated as an electric current which flows when the voltage V indicated in the circuit model in Fig. 4 is equal to a lower limit voltage Vmin used by the vehicle system.

Therefore, Expression (6) is obtained by transforming Expression (1) with respect to the electric current I. The basic calculation content is the same as the allowable electric charging current Ichg in Expression (2), but an expression is transformed so that Idis becomes a positive value in consideration of the fact that the direction of the electric current is opposite.

[Math. 6]

$$I_{dis} = \frac{(OCV(SOC,T) + Vp) - Vmin}{Ro(SOC,T) \times \dfrac{SOHR}{100}} \quad \text{... Expression (6)}$$

Expression (7) is an expression to represent the dischargeable electric current Imax, dis which is obtained by restricting the upper limit electric current Ilimit of the system as the maximum electric current in the same manner as the calculation of the allowable electric current Imax, chg. The limitation is imposed on Idis, which is obtained from the circuit model, so that it will not become equal to or more than the upper limit electric current Ilimit of the system. Accordingly, the maximum allowable electric current Imax, dis can be obtained.

[Math. 7]

$$I_{max,dis} = \min(I_{dis}, Ilimit) \quad \text{... Expression (7)}$$

Expression (8) is an expression to represent the dischargeable voltage Vmax, dis. It is the voltage V when the allowable electric discharge current Imax, dis is made to flow through the circuit model in Fig. 4 and is calculated by applying it to Expression (1). Similarly to Imax, dis, the OCV is calculated by using the OCV map. Furthermore, the current battery degradation is reflected in the Ro, which is calculated from the Ro map of a new battery, and the obtained result is multiplied by the degradation rate SOHR of the battery in order to make it closer to the actual Ro.

[Math. 8]

$$V_{max,dis} = OCV(SOC,T) + I_{max,dis} \times R_0(SOC,T) \times \frac{SOHR}{100} + Vp \quad \text{... Expression (8)}$$

The allowable electric power per battery is obtained by a product of the dischargeable voltage Vmax, dis and the allowable electric discharge current Imax, dis which are obtained above. In consideration of the fact that this exists for N pieces of batteries of the assembled battery 110, the allowable electric discharge power after the calculation unit Wdis which is the output from the allowable electric power calculation unit 153 in Embodiment 1 is obtained in accordance with Expression (5).

[Math. 9]

$$W_{dis} = I_{max,dis} \times V_{max,dis} \times N \quad \text{... Expression (9)}$$

[Regarding Allowable Electric Power Limitation Unit]

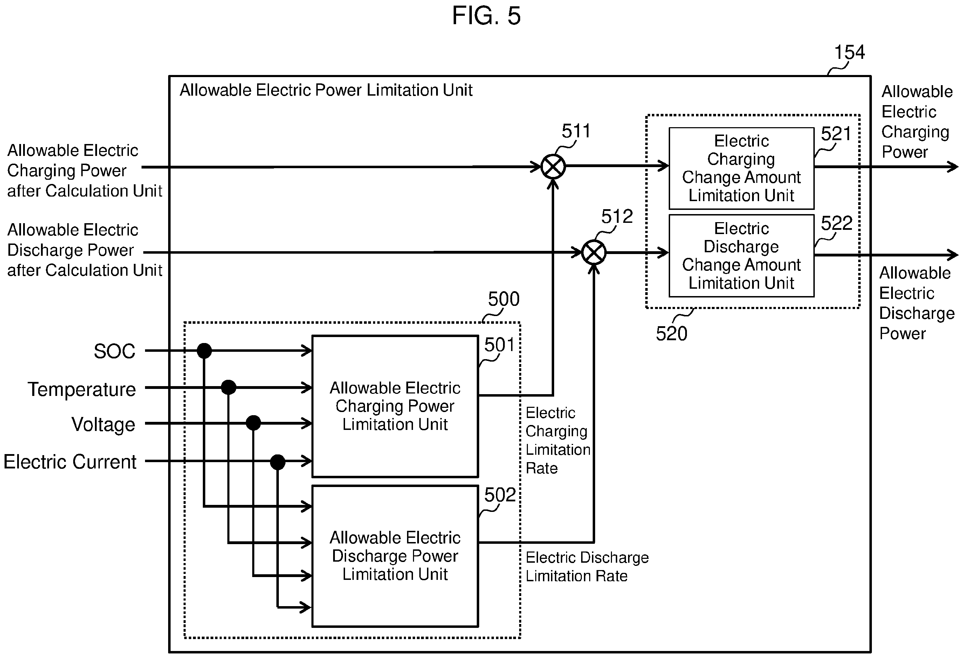

Fig. 5 is a block diagram illustrating the further details of the allowable electric power limitation unit 154 in this system 100 in Fig. 1. Multiplication units 511, 512 multiply the allowable electric power after the calculation unit by a limitation rate.

Under this circumstance, the allowable electric power after the calculation unit is an output of the allowable electric power calculation unit 153 and is the allowable electric charging power after the calculation unit and the allowable electric discharge power after the calculation unit. Furthermore, the limitation rate is an output of an allowable electric power limitation unit 500 and is an electric charging limitation rate and an electric discharge limitation rate. These are output respectively from an allowable electric charging power limitation unit 501 and an allowable electric discharge power limitation unit 502 for the allowable electric power limitation unit 500.

The limitation rate which is the result of the above is input to a change amount limitation unit 520 (an electric charging change amount limitation unit 521 and an electric discharge change amount limitation unit 522) and final allowable electric power (the allowable electric charging power and the allowable electric discharge power) is calculated.

The allowable electric power limitation unit 500 is configured from the allowable electric charging power limitation unit 501 and the allowable electric discharge power limitation unit 502, which respectively receive battery status values (the SOC, voltages, electric currents, and temperatures in this example) as inputs and calculate the limitation rate (the electric charging limitation rate and the electric discharge limitation rate) to limit the allowable electric power after the calculation unit to 100% (no limitation) through 0% (0 kW).

The allowable electric charging power limitation unit 501 calculates the electric charging limitation rate to limit the allowable electric charging power, detects any overcharge voltage, excessively high SOC, anomalous electric current, and anomalous temperature and limits the allowable electric charging power. Since the voltage and the SOC rise during the electric charging, there is a risk of causing the overcharge. Therefore, when the voltage and the SOC are monitored and if the overcharge voltage occurs or the SOC exceeds an upper-limit SOC which is determined for the system, it becomes necessary to impose the limitation.

When the electric current is monitored and if an excessive electric current which might destroy the system or the battery is made to flow continuously, it also becomes necessary to limit the electric power. Furthermore, when the temperature of the battery is monitored and if it becomes a high temperature or a low temperature which exceeds an allowable limit and the battery enters into a dangerous state, it becomes also necessary to limit the electric power in the same manner. The allowable electric discharge power limitation unit 502 calculates the electric discharge limitation rate to limit the allowable electric discharge power, detects any overdischarge voltage, excessively low SOC, anomalous electric current, and anomalous temperature, and limits the allowable electric charging power.

Since the voltage or the SOC decreases during the electric discharge, the risk of overdischarging occurs. Therefore, when the voltage and the SOC are monitored and if the overdischarge voltage occurs or the SOC becomes lower than a lower-limit SOC determined for the system, it becomes necessary to impose the limitation. When the electric current is monitored and if an excessive electric current which might destroy the system or the battery is made to flow continuously, it also becomes necessary to limit the electric power in the same manner as the electric charging limitation rate. Furthermore, when the temperature of the battery is monitored and if it becomes a high temperature or a low temperature which exceeds an allowable limit and the battery enters into a dangerous state, it becomes also necessary to limit the electric power in the same manner.

The change amount limitation unit 520 is configured from the electric charging change amount limitation unit 521 and the electric discharge change amount limitation unit 522 and limits a maximum change amount per unit time in order to suppress any steep value changes with respect to the allowable electric charging power and the allowable electric discharge power which are limited by the limitation rate and are outputs from the multiplication units 511, 512.

Therefore, the allowable electric power calculation process by the allowable electric power computing unit 152 is as follows. Firstly, the allowable electric power calculation unit 153 calculates the allowable electric power (the allowable electric power after the calculation unit) by using the circuit model. The allowable electric power limitation unit 154 provides various limitations based on the above and generates final allowable electric power.

<Limitation Rate Calculation Method According to Embodiment 1>

Next, an explanation will be provided about a limitation rate calculation method by the allowable electric power limitation unit 500.

An electric charging limitation rate Dchg which is an output of the allowable electric charging power limitation unit 501 is represented by Expression (10). Under this circumstance, Dmax_chg is a maximum limitation rate value of the limitation rate Dchg. Dvol_chg is a limitation rate which is limited with the overcharge voltage according to the voltage. Dsoc_chg is a limitation rate which is limited with the upper-limit SOC according to the SOC. Dcur is a limitation rate which is limited with the anomalous electric current according to the electric current. Dtemp is a limitation rate which is limited with the anomalous temperature according to the temperature.

After calculating the respective limitation rates, the allowable electric charging power limitation unit 501 sets the respective limitation rates as values of 0-100%, and decides the electric charging limitation rate Dchg in accordance with these minimum values for the sake of the safety. Specifically speaking, if an anomaly has occurred with respect to any one of indexes indicating the battery status, such as the voltage, the electric current, the temperature, and the SOC, the allowable electric charging power limitation unit 501 imposes the limitation on the allowable electric power. When this happens, the electric charging limitation rate Dchg is decided in accordance with the strictest limitation rate.

The electric charging limitation rate Dchg according to Embodiment 1 is set as a value between 0% and Dmax_chg(%). Incidentally, if Dmax_chg is set as 100%, the electric charging limitation rate Dchg can be calculated based on the limitation rates Dvol_chg, Dsoc_chg, Dcur, and Dtemp.

Furthermore, if Dmax_chg is set as a value less than 100%, the upper limit of the limitation rate can be designated according to elements other than the voltage, the SOC, the electric current, and the temperature. Specifically speaking, Dmax_chg may be used to set the upper limit of the limitation rate due to factors other than the battery status with respect to the allowable electric power after the calculation unit. Alternatively, it may be used to set the limitation rate with respect to the allowable electric power after the calculation unit so that it should not always be 100%, but should have some surplus.

[Math. 10]

$$D_{chg} = \min\left( D_{\max\_chg}, D_{vol\_chg}, D_{SOC\_chg}, D_{cur}, D_{temp} \right) \ldots \text{Expression (10)}$$

Similarly, the electric discharge limitation rate Ddis which is an output of the allowable electric discharge power limitation unit 502 is represented by Expression (11). Under this circumstance, Dmax_dis is a maximum limitation rate value of the limitation rate Ddis. Dvol_dis is a limitation rate which is limited with the overdischarge voltage according to the voltage. Dsoc_dis is a limitation rate which is limited with the lower-limit SOC according to the SOC. Dcur is a limitation rate which is limited with the anomalous electric current according to the electric current. Dtemp is a limitation rate which is limited with the anomalous temperature according to the temperature. The respective limitation rates are set as 0-100%; and after their respective limitation rates are calculated, the electric discharge limitation rate Ddis is decided in accordance with their minimum values for the sake of the safety.

The electric discharge limitation rate Ddis according to Embodiment 1 is set as a value between 0% and Dmax_dis(%). If Dmax_dis is set as 100%, the electric charging limitation rate Ddis can be calculated based on the limitation rates Dvol_dis, Dsoc_dis, Dcur, and Dtemp.

Furthermore, if Dmax_chg is set as a value less than 100%, the upper limit of the limitation rate can be designated according to elements other than the voltage, the SOC, the electric current, and the temperature. Specifically speaking, Dmax_chg may be used to set the upper limit of the limitation rate due to factors other than the battery status with respect to the allowable electric power after the calculation unit. Alternatively, it may be used to set the limitation rate with respect to the allowable electric power after the calculation unit so that it should not always be 100%, but should have some surplus.

[Math. 11]

$$D_{dis} = \min\left( D_{\max\_dis}, D_{vol\_dis}, D_{SOC\_dis}, D_{cur}, D_{temp} \right) \; ... \; \text{Expression (11)}$$

<Description of Limitation Rate According to Voltage>

Next, an explanation will be provided about a method for calculating the electric charging limitation rate Dvol_chg according to the aforementioned voltage and the electric discharge limitation rate Dvol_dis according to the aforementioned voltage in Embodiment 1. For ease of explanation, an allowable electric power limiting method (a limitation rate calculation method according to the voltage) relating to comparative examples and their problems will be explained in advance. As compared to that, the allowable electric power limiting method according to Embodiment 1 and its advantageous effects will be explained.

<Method for Calculating Allowable Electric Charging Power Limitation Rate According to Comparative Example>

Regarding the allowable electric power limiting method according to comparative examples, there are an electric charging limitation method (corresponding to the electric charging limitation rate Dvol_chg) and an electric discharge limitation method (corresponding to the electric discharge limitation rate Dvol_dis).

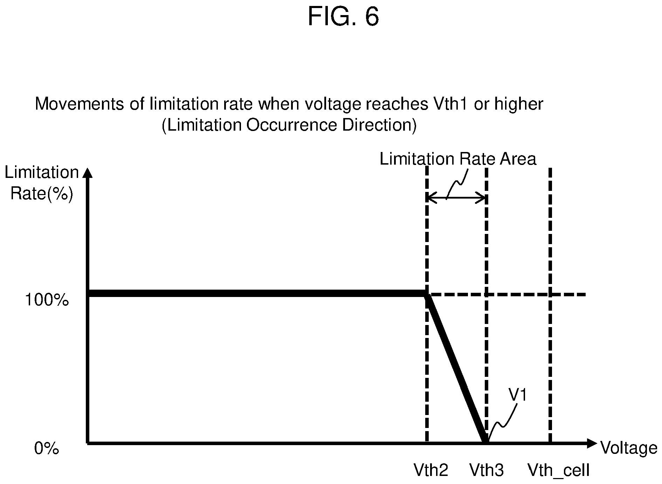

Fig. 6 is a graph illustrating the electric charging limitation method of a comparative example (hereinafter also referred to as the "electric charging limitation method of the comparative example") and corresponds to the electric charging limitation rate Dvol_chg. A horizontal axis of Fig. 6 represents the voltage and its vertical axis represents the limitation rate. The right side of the horizontal axis is considered as a voltage increase direction. Regarding the voltage on the horizontal axis, a second voltage threshold value Vth2 is a voltage threshold value to start the limitation and cancel the limitation.

A third voltage threshold value Vth3 is a voltage threshold value to end the limitation (the voltage threshold value to make the limitation rate 0%). A voltage value Vth_cell represents a voltage threshold value which the battery voltage should not exceed. In Embodiment 1, it is defined as an overcharge voltage threshold value of the battery. Firstly, the relationship between the voltage and the limited state will be explained.

The voltage in normal operation is a voltage lower than Vth2 and the allowable electric charging power is in the state of no limitation (the limitation rate: 100%) under this circumstance. If the electric charging is performed from this voltage state, the voltage rises. When the voltage becomes equal to or higher than Vth2, the allowable electric charging power is limited according to the limitation rate on the limitation rate (100% to 0%) slope. When the voltage becomes equal to or higher than Vth3, the limitation rate becomes 0%.

When the voltage is in a state of Vth2 or higher, the limitation rate is decided uniquely according to the voltage in accordance with the above-mentioned limitation rate slope. Specifically speaking, when the voltage becomes equal to or higher than Vth2, the system enters into a state of the limitation occurrence and the calculation is performed so that the limitation rate will be always updated according to the voltage based on the above-mentioned limitation rate slope.

When the voltage becomes equal to or lower than Vth2 after the limitation occurrence, the system enters into a state of the limitation cancellation and the limitation rate returns to 100%. Specifically speaking, the system enters into a state of no limitation. Regarding the electric charging limitation method of the above-described comparative example, there is a possibility that hunting behaviors of the voltage described below may occur and the allowable electric power may fluctuate considerably, thereby causing operation instability of the vehicle system.

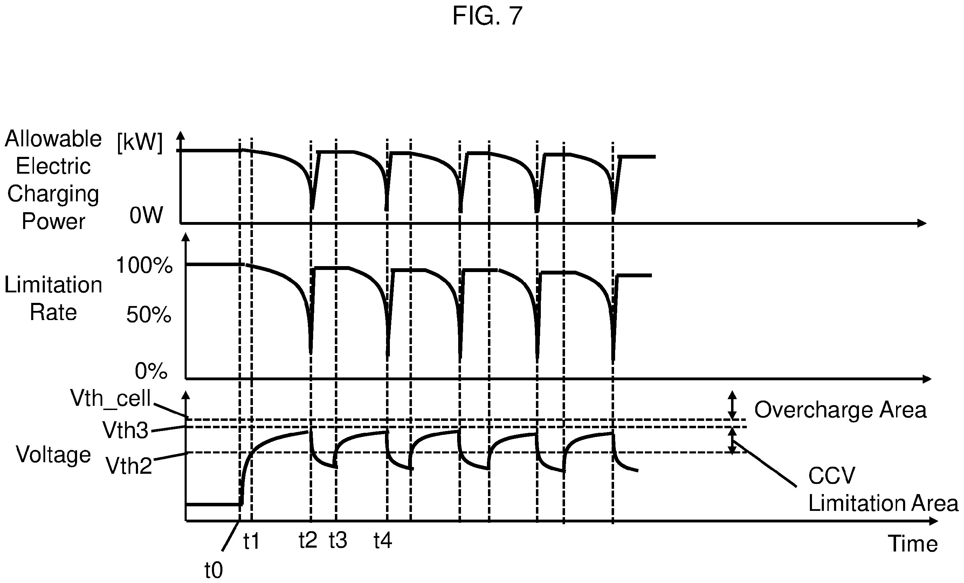

Fig. 7 is a graph illustrating a hunting phenomenon which may occur with respect to the electric charging limitation method of the comparative example in Fig. 6. It consists of three graphs of the allowable electric charging power, the limitation rate, and the voltage as shown in Fig. 7 and a horizontal axis represents time (Time). As the graph goes toward the right side, it indicates the elapse of time. Firstly, regarding time t0 or before then, the voltage is equal to or lower than Vth2 and can be considered to be within a normal voltage range. The limitation rate is 100% and the allowable electric charging power is equivalent to the allowable electric charging power after the calculation unit.

It is assumed that steep or significant electric charging will occur from this state. The electric charging occurs at time t0; and if the voltage rises rapidly, the voltage reaches Vth2 by time t1. As the voltage reaches Vth2, the limitation of the allowable electric charging power occurs, the limitation rate according to the voltage is calculated, and the limitation is imposed on the allowable electric charging power. As a result of a leaping rise of the battery voltage caused by rapid charging at and after time t1, the voltage continues rising. With the vehicle system, a maximum value of the electric power for charging is limited with respect to the allowable electric charging power, so that charging the battery is limited along with a decrease of the allowable electric charging power.

Immediately before time t2, the allowable electric charging power is sufficiently limited and the battery voltage will not increase any more. As a result of the occurrence of the limitation on the allowable electric charging power, the battery voltage decreases to Vth2 or lower by time 2 and recovers to the normal voltage again. The limitation is cancelled at and after time t2 once. When this happens, the limitation rate instantly becomes 100% (the state of no limitation) because of the limitation cancellation and the allowable electric charging power also thereby recovers to the allowable electric charging power after the calculation unit.

Consequently, the system enters into a rechargeable allowable electric power state. However, immediately after this limitation cancellation, it is assumed that the battery voltage is still in a state sufficiently close to the second voltage threshold value Vth2 when the limitation occurrence starts. Under this circumstance, if the vehicle immediately starts charging, the limitation of the allowable electric charging power will occur again by time t3 due to the rise of the voltage.

When the time turns to time t4, the voltage becomes equal to or lower than Vth2 again and the limitation is thereby cancelled. However, even after time t4, repetitions (hunting behaviors) of the limitation occurrence and the limitation cancellation will occur in the same manner in short cycles. Accordingly, with the vehicle system which controls electric charging according to the allowable electric charging power, the allowable electric charging power fluctuates considerably in a short period of time and operations become unstable. Next, an explanation will be provided about an electric discharge limitation method according to a comparative example.

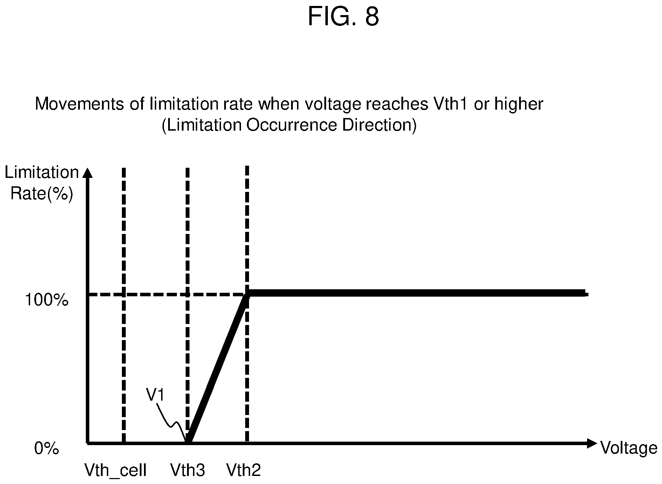

Fig. 8 is a graph illustrating the electric discharge limitation method of a comparative example (the electric discharge limitation method of the comparative example) and corresponds to the electric charging limitation rate Dvol_dis. In Fig. 8, a horizontal axis represents the voltage and a vertical axis represents the limitation rate. As the horizontal axis goes toward to the left side, the voltage becomes lower and a decrease direction is indicated. The second voltage threshold value Vth2 is a voltage threshold value to start the limitation and cancel the limitation.

The third voltage threshold value Vth3 is a voltage threshold value to end the limitation (the voltage threshold value to make the limitation rate 0%). The voltage value Vth_cell is a lower-limit voltage threshold value defined in the specifications. If the system is used in a manner such that the battery voltage falls below it, it is believed that it will adversely affect the life of the battery. In Embodiment 1, it is an overdischarge voltage threshold value of the battery.

Firstly, the relationship between the voltage and the limited state will be explained. The voltage in normal operation is a voltage higher than Vth2; and under this circumstance, the allowable electric charging power is in the state of no limitation (the limitation rate: 100%). When the electric discharge is performed from this voltage state, the voltage falls. When the voltage becomes equal to or lower than Vth2, the allowable electric discharge power is limited according to the limitation rate on the limitation rate (100% to 0%) slope.

When the voltage becomes equal to or lower than Vth3, the limitation rate becomes 0%. In the state where the voltage is equal to or lower than Vth2, the limitation rate is decided uniquely according to the voltage on the basis of the above-mentioned limitation rate slope. Specifically speaking, when the voltage becomes equal to or lower than Vth2, the system enter into a state of the limitation occurrence and the limitation rate according to the voltage is always updated and calculated based on the above-mentioned limitation rate slope.

When the voltage becomes equal to or higher than Vth2 after the limitation occurrence, the system enter into a state of the limitation cancellation and the limitation rate returns to 100%. Specifically speaking, the system enter into a state of no limitation. Regarding the electric discharge limitation method of the above-described comparative example, there is a possibility that hunting behaviors of the voltage may occur similarly to the limitation of the allowable electric charging power and the allowable electric power may fluctuate considerably, thereby causing operation instability of the vehicle system.

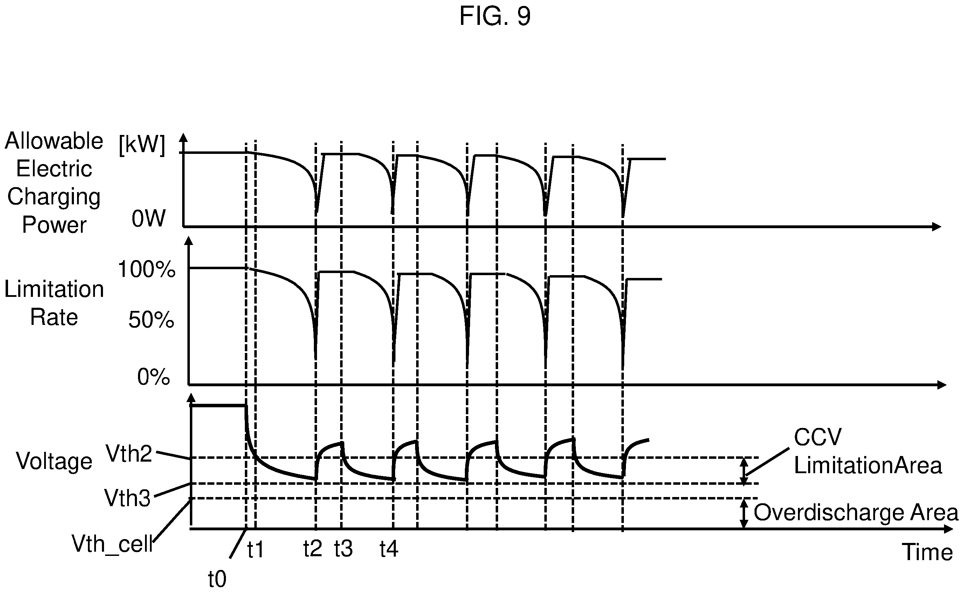

Fig. 9 is a graph illustrating a hunting phenomenon which may occur with respect to the electric discharge limitation method of the comparative example in Fig. 8. It consists of three graphs of the allowable electric discharge power, the limitation rate, and the voltage as shown in Fig. 9 and a horizontal axis represents time (Time). As the graph goes toward the right side, it indicates the elapse of time. Firstly, regarding time t0 or before then, the voltage is equal to or higher than Vth2 and can be considered to be within a normal voltage range. The limitation rate is 100% and the allowable electric discharge power is equivalent to the allowable electric discharge power after the calculation unit.

It is assumed that steep or significant electric discharge will continue at and after time t0 in Fig. 9. The voltage falls rapidly due to the electric discharge from time t0 and then reaches Vth2 at time t1. After the voltage reaches Vth2, the allowable electric discharge power limitation unit 502 calculates the limitation rate according to the voltage and limits the allowable electric discharge power. The battery voltage falls due to the electric discharge which continues even after time t1.

With the vehicle system, a maximum value of the electric power for the electric discharge is limited with respect to the allowable electric discharge power, so that electric discharge from the battery is limited along with a decrease of the allowable electric discharge power. Immediately before time t2, the allowable electric discharge power is sufficiently limited and the battery voltage will not decrease any more. As a result of the occurrence of the limitation on the allowable electric discharge power, the battery voltage increases to Vth2 or higher by time 2 and recovers to the normal voltage again. The limitation is cancelled at and after time t2 once.

When this happens, the limitation rate instantly becomes 100% (the state of no limitation) because of the limitation cancellation and the allowable electric discharge power also thereby recovers to the allowable electric discharge power after the calculation unit. Consequently, the system enters into an allowable electric power state capable of electric discharge again. However, immediately after this limitation cancellation, it is assumed that the battery voltage is still in a state sufficiently close to the second voltage threshold value Vth2 when the limitation occurrence starts. Under this circumstance, if the vehicle immediately starts electric discharge, the limitation of the allowable electric discharge power will occur again by time t3 due to the reduction of the voltage.

When the time turns to time t4, the voltage becomes equal to or higher than Vth2 again and the limitation is thereby cancelled. However, even after time t4, the hunting which repeats the limitation occurrence and the limitation cancellation in short cycles will occur in the same manner. Accordingly, the vehicle system which controls the electric discharge according to the allowable electric discharge power experiences considerable fluctuations of the allowable electric discharge power in a short period of time and may easily become subject to operation instability.

<Limitation Rate Calculation Method According to Embodiment 1>

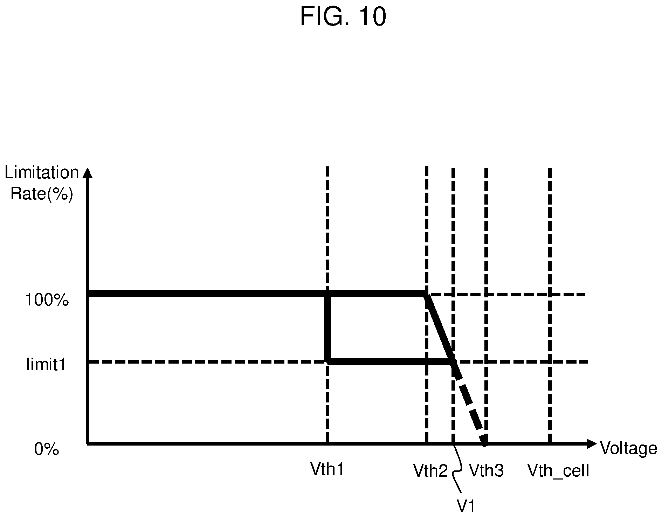

The electric charging limitation method and the electric discharge limitation method according to Embodiment 1 will be sequentially explained below. Fig. 10 is a graph illustrating the electric charging limitation method for this system 100 in Fig. 1 (hereinafter also referred to as "this electric charging limitation method"). This electric charging limitation method is different from the electric charging limitation method of the comparative example illustrated in Fig. 6 with respect to how to calculate the limitation rate and voltage threshold values relating to the limitation occurrence and the limitation cancellation.

Regarding the voltage on the horizontal axis unlike Fig. 6, the second voltage threshold value Vth2 serves only as a voltage threshold value to start the limitation start and the first voltage threshold value Vth1 is an independent voltage threshold value to cancel the limitation. The third voltage threshold value Vth3 is a voltage threshold value to end the limitation (the voltage threshold value to make the limitation rate 0%).

Firstly, the relationship between the voltage and the limited state will be explained. The voltage in normal operation is a voltage lower than Vth2; and under this circumstance, the allowable electric charging power is in the state of no limitation (the limitation rate: 100%). When the electric charging is performed from this voltage state, the voltage rises. When the voltage becomes equal to or higher than Vth2, the allowable electric charging power is limited according to the limitation rate on the limitation rate (100% to 0%) slope. When the voltage becomes equal to or higher than Vth3, the limitation rate becomes 0%.

The difference from the electric charging limitation method according to the comparative example in Fig. 6 is that during a period of time from the limitation occurrence to the limitation cancellation (until the voltage becomes equal to or lower than the first voltage threshold value Vth1 for the limitation cancellation), the limitation rate which has decreased once upon the rise of the voltage will be maintained even if the voltage decreases. Specifically speaking, the limitation rate is calculated as described below by explaining the rise of the voltage and the fall of the voltage separately.

An explanation will be provided about a voltage rise direction. When there is no history of limitation and the voltage is lower than Vth2, the limitation rate is 100%. When the voltage becomes equal to or higher than Vth2, the limitation rate is calculated and updated according to the voltage based on the limitation rate slope (100% to 0%). However, let us assume that the voltage continues rising without falling even at once. The voltage when the rise of the voltage stops is defined as V1; and the limitation at that time is defined as limit1.

Under this circumstance, if V1 is a voltage between Vth2 and Vth3, limit1 becomes the limitation rate on the limitation rate slope of 100% to 0%; and if V1 is equal to or higher than Vth3, limit1 becomes the limitation rate 0%. V1 in Fig. 10 is an example between Vth2 and Vth3.

Let us assume that after the voltage reaches V1, the voltage falls from here toward the first voltage threshold value Vth1 for the limitation cancellation. In this case, the limitation rate limit1 which is experienced at V1 will be maintained until the voltage becomes equal to or lower than the first voltage threshold value Vth1 for the limitation cancellation. When the voltage becomes equal to or lower than Vth1, the limitation is cancelled. As the limitation rate instantly becomes 100% (the state of no limitation), the allowable electric charging power also recovers to the allowable electric charging power after the calculation unit.

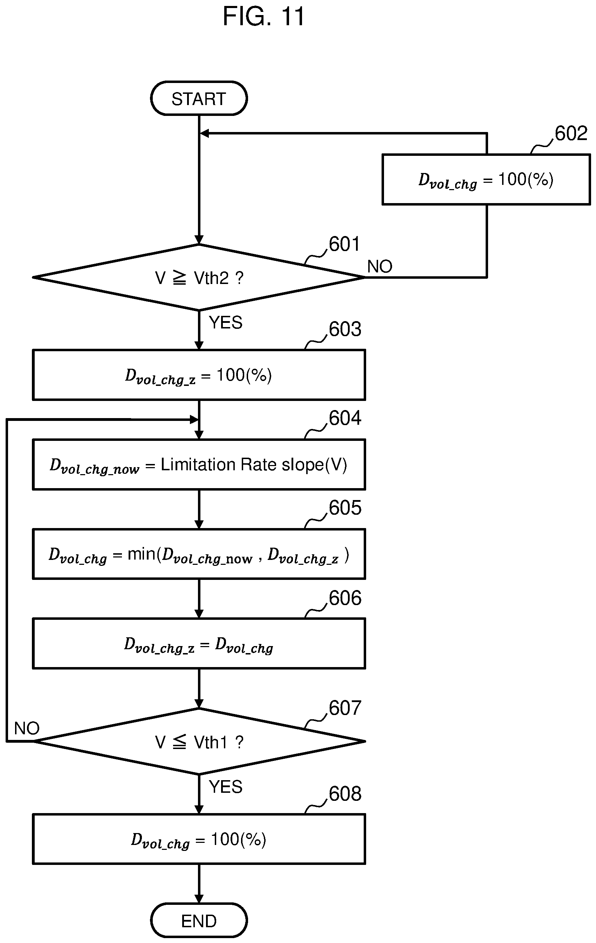

Fig. 11 is a flowchart illustrating processing from the limitation occurrence to the limitation cancellation regarding this electric charging limitation method in Fig. 10. In the flowchart in Fig. 11, the current voltage is represented by V, a flow starting point is before the limitation occurrence, and the voltage V is lower than Vth2. An explanation will be provided here about a processing method from the limitation occurrence to the limitation cancellation by monitoring the voltage periodically and always continuing updating the current voltage. Dvol_chg represents the allowable electric charging power limitation rate (the limitation rate according to the voltage) in Embodiment 1. Dvol_chg_z is a previous value of Dvol_chg.

Dvol_chg_now is the limitation rate obtained when the current voltage V is applied to the limitation rate slope in Fig. 10. Specifically speaking, in a case of Vth2≤V≤Vth3, it is the limitation rate on the limitation rate slope; and in a case of V≥Vth3, the limitation rate is 0%.

The voltage is a normal voltage at a starting point. Regarding a judgment 601 (Expression (12)), a judgment result "NO" is always returned, processing 602 (Expression (13)) is performed, and (Dvol_chg=100%) is maintained.

When the voltage V rises and becomes equal to or higher than Vth2, "YES" is returned to the judgment 601 (Expression (12)) and processing 603, 604, 605 is executed consecutively.

The processing 603 (Expression (14)) is initialization processing for applying the value 100% to Dvol_chg_z.

The processing 604 (Expression (15)) is the limitation rate obtained when the current voltage V is applied to the limitation rate slope as explained above with respect to Dvol_chg_now. The limitation rate of Dvol_chg_now fluctuates according to the current voltage.

The processing 605 (Expression (16)) is processing for updating the current limitation rate Dvol_chg. A minimum value between the limitation rate Dvol_chg_now which is obtained by applying the current voltage to the limitation rate slope, and the previous limitation rate Dvol_chg_z is adopted and applied to the limitation rate Dvol_chg. While the current voltage continues rising, the limitation rate Dvol_chg keeps being updated towards the limitation rate 0%.

Furthermore, "if the current voltage decreases" or "if the current voltage does not fluctuate at all," the limitation rate Dvol_chg does not change. This is because during the processing 605 (Expression (16)), the limitation rate Dvol_chg_now shows a value closer to the limitation rate 100% in response to the decrease of the voltage and, therefore, the previous limitation rate Dvol_chg_z is always selected as the minimum value.

Processing 606 (Expression (17)) is processing for updating the previous value Dvol_chg_z of Dvol_chg with the current Dvol_chg.

A judgment 607 (Expression (18)) is processing for judging whether the current voltage V has become equal to or lower than the cancellation voltage Vth1 or not. If the current voltage V has become equal to or lower than the cancellation voltage Vth1, processing 608 (Expression (13)) is executed and the limitation rate Dvol_chg is returned to 100%.

If it is determined that the current voltage V is higher than the cancellation voltage Vth1, loop processing for executing the processing 604, 605, 606 again is performed in order to continue the limitation. As a result of the above-described processing flow, the sequence of processing from the limitation occurrence to the limitation cancellation can be performed by the electric charging limitation method according to Embodiment 1.

[Math. 12]

$$V \geqq Vth2 \ \dots \ \text{Expression (12)}$$

$$D_{vol\_chg} = 100(\%) \ \dots \ \text{Expression (13)}$$

$$D_{vol\_chg\_z} = 100(\%) \ \dots \ \text{Expression (14)}$$

$$D_{vol\_chg\_now} = Limitation\ Rate\ slope(V) \ \dots \ \text{Expression (15)}$$

$$D_{vol\_chg} = \min\left( D_{vol\_chg\_now}, D_{vol\_chg\_z} \right) \ \dots \ \text{Expression (16)}$$

$$D_{vol\_chg\_z} = D_{vol\_chg} \ \dots \ \text{Expression (17)}$$

$$V \leqq Vth1 \ \dots \ \text{Expression (18)}$$

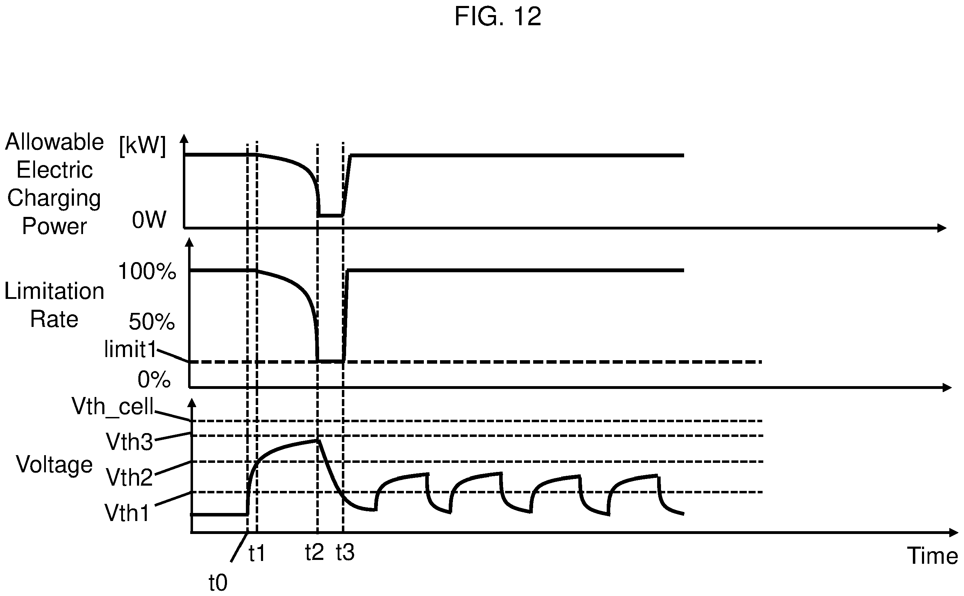

Fig. 12 is a graph illustrating application effects of this electric charging limitation method in Fig. 10 and Fig. 11. It consists of three graphs of the allowable electric charging power, the limitation rate, and the voltage as shown in Fig. 12 and a horizontal axis represents time (Time). As the graph goes toward the right side, it indicates the elapse of time. Firstly, regarding time t0 or before then, the voltage is lower than Vth2 and can be considered to be within a normal voltage range. The limitation rate is 100% and the allowable electric charging power is equivalent to the allowable electric charging power after the calculation unit.

It is assumed that steep or significant electric charging will occur from this state. The electric charging occurs at time t0; and if the voltage rises rapidly, the voltage reaches Vth2 by time t1. As the voltage reaches Vth2, the limitation of the allowable electric charging power occurs, the limitation rate according to the voltage is calculated, and the limitation is imposed on the allowable electric charging power. As a result of a leaping rise of the battery voltage caused by rapid charging at and after time t1, the voltage continues rising.

With the vehicle system, a maximum value of the electric power for charging is limited with respect to the allowable electric charging power, so that charging the battery is limited along with a decrease of the allowable electric charging power. Immediately before time t2, the allowable electric charging power is sufficiently limited and the battery voltage will not increase any more. Between time t2 and t3, the limitation rate limit obtained at time t2 continues to be applied. Accordingly, the limitation on the allowable electric charging power occurs and the limitation rate limit1 continues, so that the battery voltage starts to decrease at and after time t2.

You can see that in Embodiment1, unlike the electric charging limitation method according to the comparative example illustrated in Fig. 7, the limitation is not cancelled even if the voltage becomes equal to or lower than Vth2 between time t2 and t3. At time t3, the voltage becomes equal to or lower than the first voltage threshold value Vth1 for the limitation cancellation and the limitation is cancelled. Since the limitation cancellation causes the limitation rate to instantly become 100% (the state of no limitation), the allowable electric charging power also recovers to the allowable electric charging power after the calculation unit.

In Embodiment 1 similarly to the electric charging limitation method according to the comparative example illustrated in Fig. 7, if the electric charging is performed immediately after the limitation cancellation, the voltage fluctuations including rises may occur even after the limitation cancellation (at and after time t3).

However, the first voltage threshold value Vth1 for the limitation cancellation is set to be lower than the second voltage threshold value Vth2 for the limitation occurrence, so that even if the voltage rises steeply, the voltage will not reach the second voltage threshold value Vth2 for the limitation occurrence and the limitation occurrence will not happen again immediately after the limitation cancellation. Specifically speaking, if the electric charging limitation method according to Embodiment 1 is employed, it is possible to prevent unstable behaviors of the allowable electric charging power caused by repetitions of the limitation occurrence and the limitation cancellation in a short period of time.

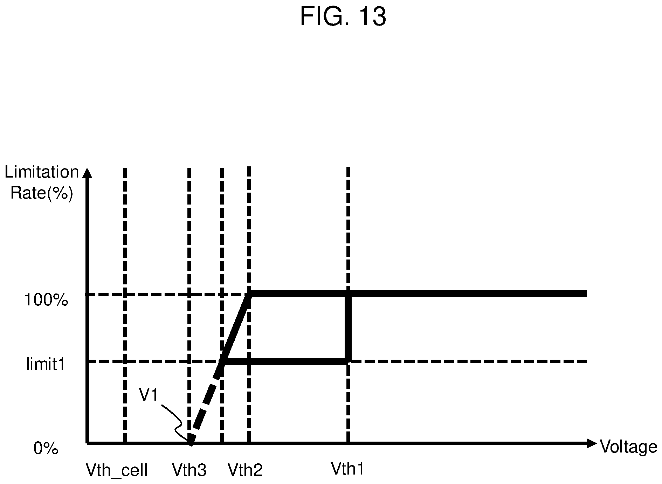

Fig. 13 is a graph illustrating the electric discharge limitation method for this system 100 in Fig. 1 (this electric discharge limitation method). This electric discharge limitation method in Fig. 13 is different from the electric discharge limitation method of the comparative example illustrated in Fig. 8 with respect to how to calculate the limitation rate, and voltage threshold values relating to the limitation occurrence and the limitation cancellation. Specifically speaking, regarding this electric discharge limitation method, unlike the method in Fig. 8, with respect to the voltage on the horizontal axis, the second voltage threshold value Vth2 serves only as a voltage threshold value to start the limitation and the first voltage threshold value Vth1 is an independent voltage threshold value to cancel the limitation. The third voltage threshold value Vth3 is a voltage threshold value to end the limitation (the voltage threshold value to make the limitation rate 0%).

Firstly, the relationship between the voltage and the limited state will be explained. The voltage in normal operation is a voltage higher than Vth2; and under this circumstance, the allowable electric discharge power is in the state of no limitation (the limitation rate: 100%). When the electric discharge is performed from this voltage state, the voltage falls. When the voltage becomes equal to or higher than Vth2, the allowable electric discharge power is limited according to the limitation rate on the limitation rate (100% to 0%) slope. When the voltage becomes equal to or lower than Vth3, the limitation rate becomes 0%.

The difference from the electric discharge limitation method according to the comparative example in Fig. 8 is that during a period of time from the limitation occurrence to the limitation cancellation (until the voltage becomes equal to or higher than the first voltage threshold value Vth1 for the limitation cancellation), the limitation rate which has decreased once upon the fall of the voltage will be maintained even if the voltage rises. Specifically speaking, the limitation rate is calculated as described below by explaining the rise of the voltage and the fall of the voltage separately.

An explanation will be provided about a voltage fall direction. When no limitation occurrence has been experienced and the voltage is higher than Vth2, the limitation rate is 100%. When the voltage becomes equal to or lower than Vth2, the limitation rate is calculated and updated according to the voltage based on the limitation rate slope (100% to 0%). However, let us assume that the voltage continues rising without rising even at once. The voltage when the fall of the voltage stops is defined as V1; and the limitation at that time is defined as limit1.

Under this circumstance, if V1 is a voltage between Vth2 and Vth3, limit1 becomes the limitation rate on the limitation rate slope of 100% to 0%; and if V1 is equal to or lower than Vth3, limit1 becomes the limitation rate 0%. V1 in Fig. 13 is an example between Vth2 and Vth3.

Let us assume that after the voltage reaches V1, the voltage rises from here toward the first voltage threshold value Vth1 for the limitation cancellation. In this case, the limitation rate limit1 which is experienced at V1 will be maintained until the voltage becomes equal to or higher than the first voltage threshold value Vth1 for the limitation cancellation. When the voltage becomes equal to or higher than Vth1, the limitation is cancelled. As the limitation rate instantly becomes 100% (the state of no limitation), the allowable electric discharge power also recovers to the allowable electric discharge power after the calculation unit.

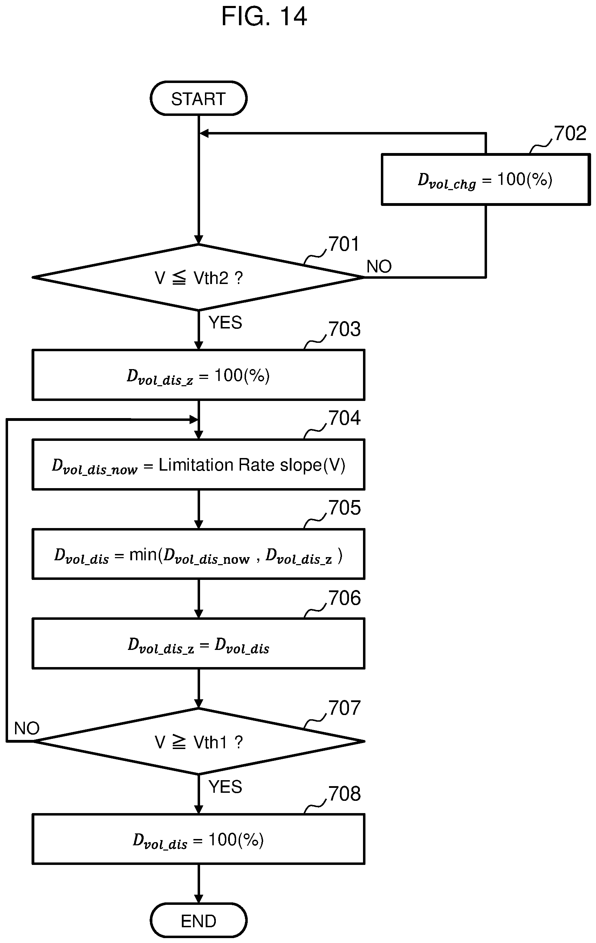

Fig. 14 is a flowchart illustrating processing from the limitation occurrence to the limitation cancellation regarding this electric discharge limitation method in Fig. 13. In the flowchart in Fig. 14, the current voltage is represented by V, a flow starting point is before the limitation occurrence, and the voltage V is higher than Vth2.

An explanation will be provided here about a processing method from the limitation occurrence to the limitation cancellation by monitoring the voltage periodically and always continuing updating the current voltage. Dvol_dis represents the allowable electric discharge power limitation rate (the limitation rate according to the voltage) in Embodiment 1. Dvol_dis_z is a previous value of Dvol_dis.

Dvol_dis_now is the limitation rate obtained when the current voltage V is applied to the limitation rate slope in Fig. 13. Specifically speaking, in a case of Vth3≤V≤Vth2, it is the limitation rate on the limitation rate slope; and in a case of V≤Vth3, the limitation rate is 0%.

The voltage is a normal voltage at a starting point. Regarding a judgment 701 (Expression (19)), a judgment result "NO" is always returned, processing 702 (Expression (20)) is performed, and (Dvol_dis=100%) is maintained. When the voltage V falls and becomes equal to or lower than Vth2, "YES" is returned to the judgment 701 (Expression (19)) and processing 703, 704, 705 is executed consecutively.

The processing 703 (Expression (21)) is initialization processing for applying the value 100% to Dvol_dis_z.

The processing 704 (Expression (22)) is the limitation rate obtained when the current voltage V is applied to the limitation rate slope as explained above with respect to Dvol_dis_now. The limitation rate of Dvol_dis_now fluctuates according to the current voltage.

The processing 705 (Expression (23)) is processing for updating the current limitation rate Dvol_dis. A minimum value between the limitation rate Dvol_dis_now which is obtained by applying the current voltage to the limitation rate slope, and the previous limitation rate Dvol_dis_z is adopted and applied to the limitation rate Dvol_dis. While the current voltage continues rising, the limitation rate Dvol_dis keeps being updated towards the limitation rate 0%.

Furthermore, "if the current voltage increases" or "if the current voltage does not fluctuate at all," the limitation rate Dvol_dis does not change. This is because during the processing 705 (Expression (23), the limitation rate Dvol_dis_now shows a value closer to the limitation rate 100% in response to the increase of the voltage and, therefore, the previous limitation rate Dvol_dis_z is always selected as the minimum value.

Processing 706 (Expression (24)) is processing for updating the previous value Dvol_dis_z of Dvol_dis with the current Dvol_dis.

A judgment 707 (Expression (25)) is processing for judging whether the current voltage V has become equal to or higher than the cancellation voltage Vth1 or not. If the current voltage V has become equal to or higher than the cancellation voltage Vth1, processing 708 (Expression (13)) is executed and the limitation rate Dvol_dis is returned to 100%.

If it is determined that the current voltage V is lower than the cancellation voltage Vth1, loop processing for executing the processing 604, 605, 606 again is performed in order to continue the limitation. As a result of the above-described processing flow, the sequence of processing from the limitation occurrence to the limitation cancellation can be performed by the electric discharge limitation method according to Embodiment 1.

[Math. 13]

$$V \leqq Vth2 \ldots \text{Expression (19)}$$

$$D_{vol\_dis} = 100(\%) \ldots \text{Expression (20)}$$

$$D_{vol\_dis\_z} = 100(\%) \ldots \text{Expression (21)}$$

$$D_{vol\_dis\_now} = Limitation \ Rate \ slope(V) \ldots \text{Expression (22)}$$

$$D_{vol\_dis} = \min\left( D_{vol\_dis\_now}, D_{vol\_dis\_z} \right) \ldots \text{Expression (23)}$$

$$D_{vol\_dis\_z} = D_{vol\_dis} \ldots \text{Expression (24)}$$

$$V \geqq Vth1 \ldots \text{Expression (25)}$$

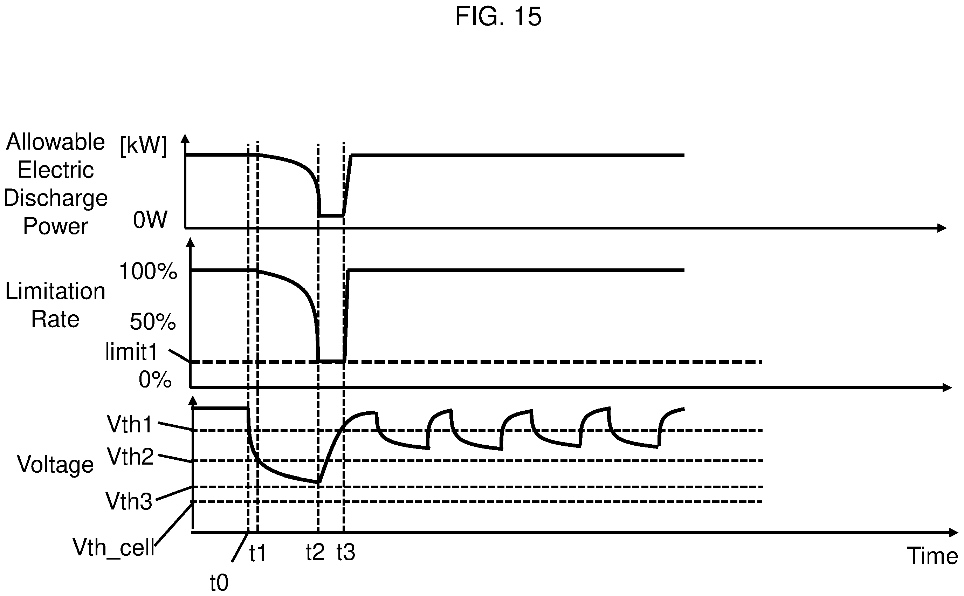

Fig. 15 is a graph illustrating application effects of this electric discharge limitation method in Fig. 13 and Fig. 14. It consists of three graphs of the allowable electric discharge power, the limitation rate, and the voltage as shown in Fig. 15 and a horizontal axis represents time (Time). As the graph goes toward the right side, it indicates the elapse of time. Firstly, regarding time t0 or before then, the voltage is a value higher than Vth2 and can be considered to be within a normal voltage range. The limitation rate is 100% and the allowable electric discharge power is equivalent to the allowable electric discharge power after the calculation unit.

It is assumed that steep or significant electric discharge will occur from this state. The electric discharge occurs at time t0; and if the voltage falls rapidly, the voltage reaches Vth2 by time t1. As the voltage reaches Vth2, the limitation of the allowable electric charging power occurs, the limitation rate according to the voltage is calculated, and the limitation is imposed on the allowable electric discharge power. As a result of a leaping fall of the battery voltage caused by rapid discharge at and after time t1, the voltage continues falling.

With the vehicle system, a maximum value of the electric power for discharge is limited with respect to the allowable electric discharge power, so that the electric discharge from the battery is limited along with a decrease of the allowable electric discharge power. Immediately before time t2, the allowable electric discharge power is sufficiently limited and the battery voltage will not decrease any more. Between time t2 and t3, the limitation rate limit obtained at time t2 continues to be applied. Accordingly, the limitation on the allowable electric discharge power occurs and the limitation rate limit1 continues, so that the battery voltage starts to increase at and after time t2.

You can see that in Embodiment1, unlike the electric discharge power limitation method according to the comparative example illustrated in Fig. 9, the limitation is not cancelled even if the voltage becomes equal to or higher than Vth2 between time t2 and t3. At time t3, the voltage becomes equal to or higher than the first voltage threshold value Vth1 for the limitation cancellation and the limitation is cancelled. Since the limitation cancellation causes the limitation rate to instantly become 100% (the state of no limitation), the allowable electric discharge power also recovers to the allowable electric discharge power after the calculation unit.

In Embodiment 1 similarly to the electric discharge power limitation method according to the comparative example illustrated in Fig. 9, if the electric discharge is performed immediately after the limitation cancellation, the voltage fluctuations including falls may occur even after the limitation cancellation (at and after time t3). However, the first voltage threshold value Vth1 for the limitation cancellation is set to be higher than the second voltage threshold value Vth2 for the limitation occurrence, so that even if the voltage falls steeply, the voltage will not reach the second voltage threshold value Vth2 for the limitation occurrence and the limitation occurrence will not happen again immediately after the limitation cancellation.

Specifically speaking, if the electric discharge limitation method according to Embodiment 1 is employed, it is possible to prevent unstable behaviors of the allowable electric discharge power caused by repetitions of the limitation occurrence and the limitation cancellation in a short period of time. As summary of the above, if Embodiment 1 is adopted, it is possible to prevent unstable behaviors of the allowable electric discharge power caused by repetitions of the limitation occurrence and the limitation cancellation with respect to the allowable electric charging/discharge power in a short period of time.

The methods for implementing Fig. 11 and Fig. 12 have been explained as the methods for implementing Embodiment 1. However, the implementation methods are just examples and are not intended to limit the methods for implementing the allowable electric power limiting method according to Embodiment 1. Specifically speaking, there are no limitations to the sequential order of the processing by software, arithmetic elements to be used, and whether there is any addition, deletion, or functionalization of processing. Furthermore, they may be implemented by any replacement means such as electronic circuits or other hardware mechanisms.


[Embodiment 2]


Next, Embodiment 2 will be explained. In Embodiment 2, an explanation will be provided about a means of enhancing safety in addition to Embodiment 1. Regarding Embodiment 1, the electric charging limitation method according to Embodiment 1 has been described with reference to Fig. 10 and the electric discharge limitation method has been described with reference to Fig. 13, respectively. In Embodiment 1, when in the limited state the voltage reaches the first voltage threshold value Vth1 for the limitation cancellation, it is designed to instantly return the limitation rate of the allowable electric power to 100%.

In Embodiment 2, the limitation rate of the allowable electric power is not instantly returned to 100% at the first voltage threshold value Vth1 for the limitation cancellation, but a fourth voltage threshold value Vth4 is newly provided and it is designed as a mechanism such that a limitation rate slope is provided between the first voltage threshold value Vth1 and the fourth voltage threshold value Vth4 to gradually return the limitation rate. An electric charging limitation method and an electric discharge limitation method according to Embodiment 2 will be sequentially explained below.

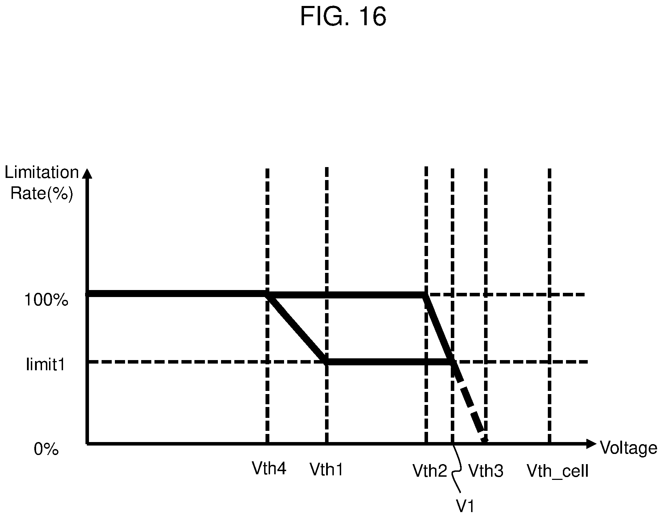

Fig. 16 is a graph illustrating the electric charging limitation method (battery control method) according to Embodiment 2. Regarding this electric charging limitation method according to Embodiment 2 as illustrated in Fig. 16, it has Vth4 which is the voltage threshold value lower than Vth1. Furthermore, a second limitation rate slope is provided between the first voltage threshold values Vth1 and Vth4. This second limitation rate slope is designed so that when the voltage is the first voltage threshold value Vth1, the limitation rate becomes limit1; and when the voltage is $Vth4 \leq V \leq Vth1$, the limitation rate becomes a limitation rate on the limitation rate slope according to the voltage. It is the mechanism such that when the voltage falls and reaches Vth4 or lower, the limitation rate is returned to 100%.

Behaviors of the limitation rate will be performed hereinafter with respect to the voltage of the limitation cancellation after the limitation occurrence. An explanation will be started from a state where the voltage becomes equal to or higher than Vth2, reaches the maximum voltage value V1 which is experienced after the limitation occurrence, and then falls. In this case, the limitation rate is maintained to be limit1 which is obtained when the voltage has reached V1, in the same manner as in Embodiment 1.

The limitation rate limit1 remains as it is until the voltage reaches the first voltage threshold value Vth1 for the limitation cancellation. When the voltage further decreases and becomes the first voltage threshold value Vth1 to Vth4, the limitation rate on the second limitation rate slope according to the voltage (Vth1 : limitation rate limit1 through Vth4: limitation rate 100%) becomes the limitation rate. When the voltage becomes equal to or lower than the fourth voltage threshold value Vth4, the limitation rate is returned to 100%.

The electric charging limitation method according to Embodiment 2 has been explained above. As compared to the electric charging limitation method according to Embodiment 1 as illustrated in Fig. 10, the difference between them can be explained as that behaviors of the limitation cancellation with respect to the voltage when calculating the limitation rate are different. When the electric charging limitation method according to Embodiment 2 is employed, the behaviors are such that in the process of the voltage decreasing after the limitation occurrence, the limitation rate is gradually returned to 100% while the first voltage threshold value Vth1 for the limitation cancellation turns to Vth4.

Specifically speaking, the limitation is gradually cancelled according to the decrease of the voltage and the allowable electric charging power also gradually recovers to the allowable electric charging power after the calculation unit. By doing so, it is possible to suppress the fluctuations caused by the steep electric power recovery of the allowable electric charging power upon the limitation cancellation and prevent the unstable behaviors of the allowable electric charging power. Next, the electric discharge limitation method according to Embodiment 2 will be explained.

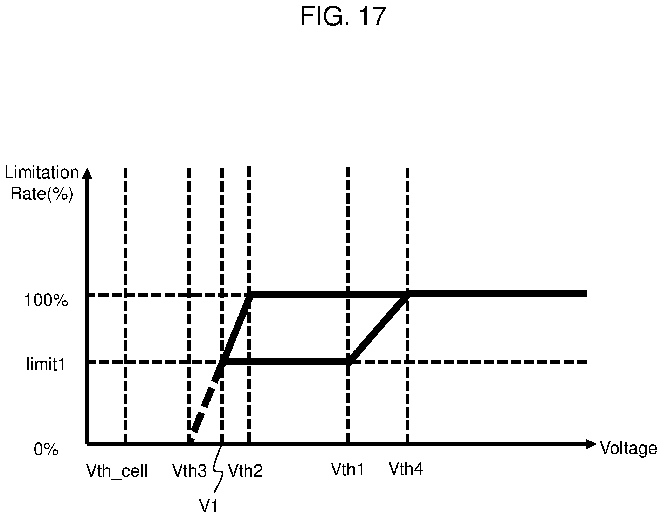

Fig. 17 is a graph illustrating the electric discharge limitation method (battery control method) according to Embodiment 2. Regarding this electric discharge limitation method according to Embodiment 2 as illustrated in the graph in Fig. 17, it has Vth4 which is the voltage threshold value higher than Vth1. Furthermore, the second limitation rate slope is provided between the first voltage threshold values Vth1 and Vth4. This second limitation rate slope is designed so that when the voltage is the first voltage threshold value Vth1, the limitation rate becomes limit1; and when the voltage is Vth1≤V≤Vth4, the limitation rate becomes a limitation rate on the limitation rate slope according to the voltage. It is the mechanism such that when the voltage rises and reaches Vth4 or higher, the limitation rate is returned to 100%.

Behaviors of the limitation rate will be performed hereinafter with respect to the voltage of the limitation cancellation after the limitation occurrence. An explanation will be started from a state where the voltage becomes equal to or lower than Vth2, reaches the minimum voltage value V1 which is experienced after the limitation occurrence, and then falls. In this case, the limitation rate is maintained to be limit1 which is obtained when the voltage has reached V1, in the same manner as in Embodiment 1.

The limitation rate limit1 remains as it is until the voltage reaches the first voltage threshold value Vth1 for the limitation cancellation. Until the voltage further increases and becomes the first voltage threshold value Vth1 to Vth4, the limitation rate on the second limitation rate slope according to the voltage (Vth1 : limitation rate limit1 through Vth4: limitation rate 100%) becomes the limitation rate. When the voltage becomes equal to or higher than the fourth voltage threshold value Vth4, the limitation rate is returned to 100%.

The electric discharge limitation method according to Embodiment 2 has been explained above. As compared to the electric discharge limitation method according to Embodiment 1 as illustrated in Fig. 13, the difference between them can be explained as that behaviors of the limitation cancellation with respect to the voltage when calculating the limitation rate are different. When the electric discharge limitation method according to Embodiment 2 is employed, the behaviors are such that in the process of the voltage rising after the limitation occurrence, the limitation rate is gradually returned to 100% while the first voltage threshold value Vth1 for the limitation cancellation turns to Vth4.

Specifically speaking, the limitation is gradually cancelled according to the rise of the voltage and the allowable electric discharge power also gradually recovers to the allowable electric discharge power after the calculation unit. By doing so, it is possible to suppress the fluctuations caused by the steep electric power recovery of the allowable electric discharge power upon the limitation cancellation and prevent the unstable behaviors of the allowable electric discharge power.

As summary of the above, if Embodiment 2 is adopted, it is possible to suppress the fluctuations caused by the steep electric power recovery of the allowable electric charging/discharge power upon the limitation cancellation and prevent the unstable behaviors of the allowable electric charging/discharge power. Specifically speaking, in addition to Embodiment 1, it is possible to further enhance the reliability of the battery control.

The second limitation slope according to this embodiment as explained with reference to Fig. 16 and Fig. 17 is a linear graph between the first voltage threshold value Vth1 and the fourth voltage threshold value Vth4. However, the graph of the second limitation slope is one example and there is no limitation to the shape of the second limitation slope used for the allowable electric power limiting method according to Embodiment 2. It may be the graph indicating the limitation rate which increases from the first voltage threshold value Vth1 to Vth4 and may be a curved line and a shape which increases in a stepped manner.

[Embodiment 3]

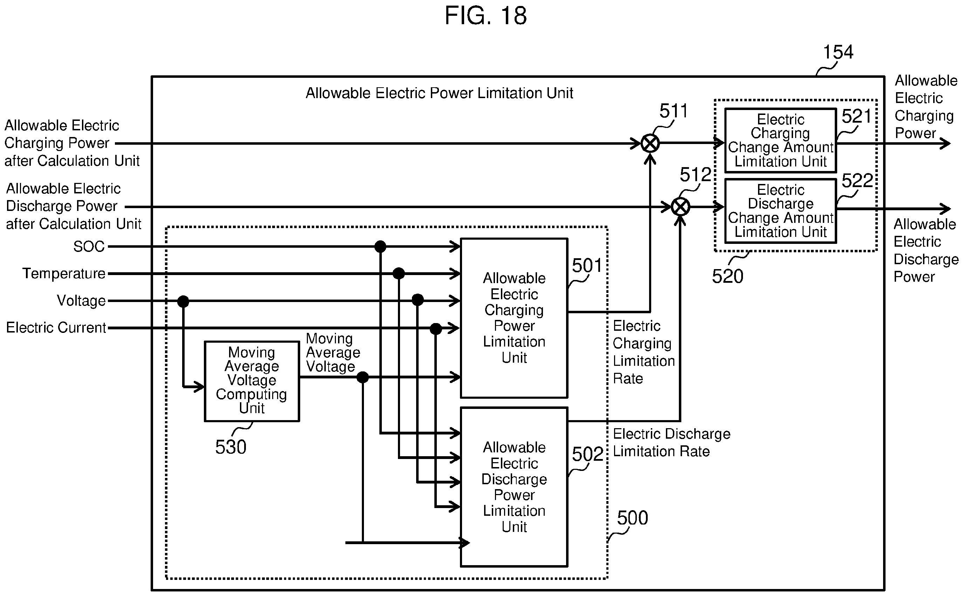

Next, Embodiment 3 will be explained with reference to Fig. 18. Fig. 18 is a block diagram illustrating an allowable electric power limitation unit according to Embodiment 3, which corresponds to the allowable electric power limitation unit 154 in Fig. 3. An allowable electric power limitation unit 500 according to Embodiment 3 as illustrated in Fig. 18 has a different configuration from that of the allowable electric power limitation unit 154 according to Embodiment 1 as illustrated in Fig. 3. The allowable electric power limitation unit 500 is newly provided with a moving average voltage computing unit 530. The moving average voltage computing unit 530 calculates a moving average value of the voltage at specified time.

Expression (26) is a mathematical expression of the moving average voltage according to Embodiment 3. Vave represents the moving average voltage. Vave_z is a previous value of the moving average voltage Vave. Ts is a sampling period indicating an update time interval for computation of the moving average voltage and τ represents a time constant.

[Math. 14]

$$V_{ave} = V \times \frac{Ts}{\tau} + V_{ave\_z} \times \left(1 - \frac{Ts}{\tau}\right) \dots \text{Expression (26)}$$

The moving average expression of Expression (26) is obtained as a transformed expression of an index moving average expression. When this index moving average expression is used, only the moving average voltage Vave may be retained in the memory for the next arithmetic operation. The moving average expression of Expression (26) is structured so that as the time constant τ increases, influences of the voltage in the past time are reflected in the arithmetic operation. Specifically speaking, to what degree the time should date back to make the past voltage data reflected in the moving average depends on the time constant T.

Specifically speaking, if the time constant τ is made large, the moving average is calculated by reflecting old voltage data in the past; and if the time constant τ is made small, the moving average is calculated by reflecting only the voltage data of the immediate past. Specifically speaking, the moving average voltage is calculated as a value in which not only the current voltage, but also the past voltage history status are reflected.

The moving average voltage calculated by the above-mentioned moving average voltage computing unit 530 is input to the allowable electric charging power limitation unit 501 and the allowable electric discharge power limitation unit 502, respectively. The moving average voltage is used to change the value of the first voltage threshold value Vth1 for the limitation cancellation by an allowable electric power limiting method to be explained next. An electric charging limitation method and an electric discharge limitation method according to Embodiment 3 will be sequentially explained below.

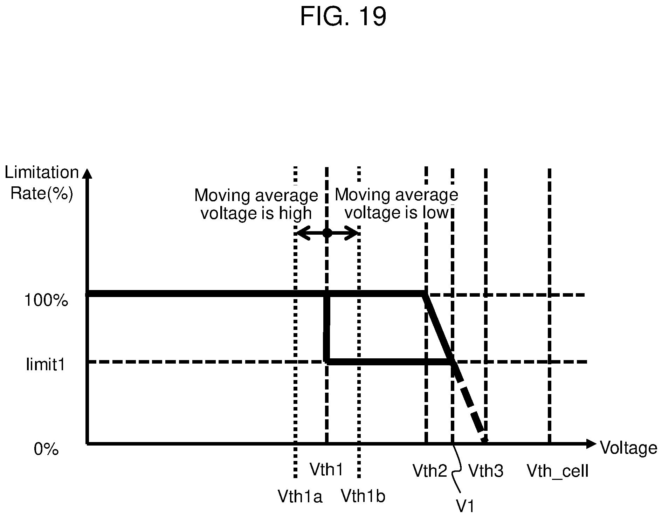

Fig. 19 is a graph illustrating the electric charging limitation method by using the allowable electric power limitation unit in Fig. 18 ("this electric charging limitation method according to Embodiment 3" or "battery control method"). As compared to this electric charging limitation method according to Embodiment 1 as illustrated in Fig. 10, this electric charging limitation method according to Embodiment 3 as illustrated in Fig. 19 is different in that the first voltage threshold value Vth1 for the limitation cancellation is a variable value according to the moving average voltage. In Embodiment 1, the first voltage threshold value Vth1 for the limitation cancellation is a fixed value. However, in Embodiment 3, the moving average voltage is monitored and the first voltage threshold value Vth1 is increased or decreased according to the moving average voltage.

When the moving average voltage is high, the first voltage threshold value Vth1 is decreased. Referring to Fig. 19, the first voltage threshold value Vth1 is moved to a voltage Vth1a. When the moving average voltage is high, there is a high possibility that the electric charging has been continuing for a long period of time; and there is a high possibility that the voltage may rise again after the limitation cancellation of the allowable electric charging power and then may result in the limitation occurrence.

Therefore, it is designed to delay the limitation cancellation until the voltage becomes sufficiently low by decreasing the first voltage threshold value Vth1 for the limitation cancellation. By doing so, it is possible to further prevent the hunting which repeats the limitation occurrence and the limitation cancellation in short time cycles. Furthermore, when the moving average voltage is low, the first voltage threshold value Vth1 is increased. Referring to Fig. 19, the first voltage threshold value Vth1 is moved to a voltage Vth1b.

When the moving average voltage is low, there is a high possibility that the electric charging is sufficiently weakened, or the electric charging has not already been performed, or it has resulted in the electric discharge. So, there is a low possibility that the voltage will not rise any more. Therefore, there is a low possibility that after the limitation cancellation of the allowable electric charging power, the voltage may rise again and may result in the limitation occurrence. As a result, the safety can be secured even if the first voltage threshold value Vth1 for the limitation cancellation is increased.

By doing so, it is possible to cancel the limitation early and expand a normal calculation range of the allowable electric charging power. Regarding the vehicle, it is possible to expand a power consumption range of the battery according to the reduction of the limitation range of the allowable electric charging power.

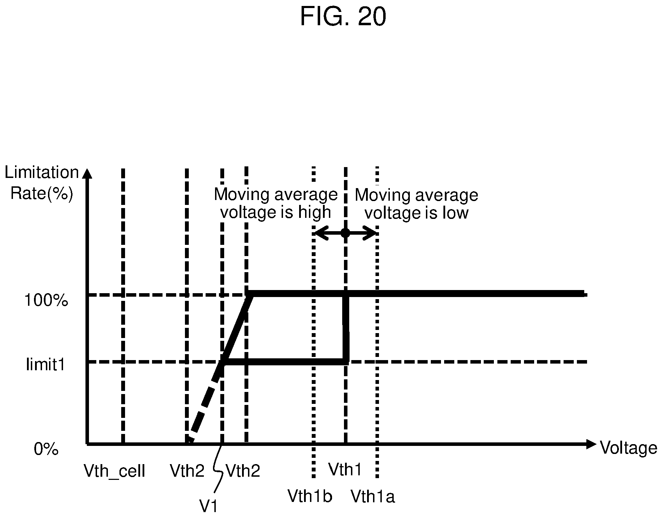

Fig. 20 is a graph illustrating the electric charging limitation method by using the allowable electric power limitation unit in Fig. 18 ("this electric discharge limitation method according to Embodiment 3" or "battery control method"). As compared to this electric discharge limitation method according to Embodiment 1 as illustrated in Fig. 13, it is different in that the first voltage threshold value Vth1 for the limitation cancellation is a variable value according to the moving average voltage. In Embodiment 1, the first voltage threshold value Vth1 for the limitation cancellation is a fixed value. However, in Embodiment 3, the moving average voltage is monitored and the first voltage threshold value Vth1 is increased or decreased according to the moving average voltage.

When the moving average voltage is low, the first voltage threshold value Vth1 is increased. Specifically speaking, as illustrated in Fig. 20, the first voltage threshold value Vth1 is moved to the voltage Vth1a. When the moving average voltage is low, there is a high possibility that the electric discharge has been continuing for a long period of time; and there is a high possibility that the voltage may fall again after the limitation cancellation of the allowable electric discharge power and then may result in the limitation occurrence. Therefore, the limitation cancellation is delayed until the voltage rises sufficiently by increasing the first voltage threshold value Vth1 for the limitation cancellation. By doing so, it is possible to enhance the effect of preventing the hunting which repeats the limitation occurrence and the limitation cancellation in short time cycles.

Furthermore, when the moving average voltage is high, the first voltage threshold value Vth1 is decreased. Referring to Fig. 19, the first voltage threshold value Vth1 is moved to the voltage Vth1b. When the moving average voltage is high, there is a high possibility that the electric discharge is sufficiently weakened, or the electric discharge has not already been performed, or it has resulted in the electric charging. So, there is a low possibility that the voltage will not decrease any more. Therefore, there is a low possibility that after the limitation cancellation of the allowable electric charging power, the voltage may fall again and may result in the limitation occurrence.

As a result, the safety can be secured even if the first voltage threshold value Vth1 for the limitation cancellation is decreased. By doing so, it is possible to cancel the limitation early and expand the normal calculation range of the allowable electric discharge power. Regarding the vehicle, it is possible to expand the power consumption range of the battery according to the reduction of the limitation range of the allowable electric discharge power.

The battery control method according to Embodiment 3 as described above increases or decreases the voltage threshold value for the limitation cancellation of the allowable electric charging/discharge power according to the moving average voltage. Consequently, it is possible to enhance the effect of preventing the hunting of the allowable electric charging/discharge power and expand the electric power use range of the vehicle.

The moving average is calculated by using the transformed expression of the index moving average expression indicated as Expression (26) as the calculation expression to calculate the moving average voltage according to Embodiment 3. However, the moving average calculation method is not limited to this example. Specifically speaking, there may be another moving average calculation method by retaining a plurality of pieces of past voltage data in the memory and calculating an average of such data.

[Supplementary Remarks]

The SOC (state of charge) means a charged state or a charging rate and is a proportion of the rest remaining after subtracting a discharged electric quantity from a secondary battery in a fully charged state; and the SOC is also called the remaining capacity. This SOC is expressed as "Remaining Capacity (Ah) / Full Charge Capacity (Ah) $\times$ 100."

The SOH (state of health) means soundness (a degraded state) of the secondary battery which is measured by using a battery tester. This SOH is expressed as "Full Charge Capacity (Ah) When Degraded / Initial Full Charge Capacity (Ah) $\times$ 100."

With the battery system equipped with a computer or a controller having functions equivalent to those of the computer, the controller monitors the voltages, electric currents, temperatures, and battery information, such as the SOC and the SOH, of the batteries and performs arithmetic processing on the allowable electric power so that the degree of output limitation will be strengthened as it becomes closer to the vicinity of an area where it become necessary to protect cells.

With the vehicle system equipped with the battery system, the battery control method calculates and applies the allowable electric power which can be used within a specified battery use range. Regarding the secondary battery which is being charged, the allowable electric charging power decreases and the allowable electric discharge power increases. Furthermore, regarding the secondary battery which is being discharged, the allowable electric discharge power decreases and the allowable electric charging power increase. Accordingly, the allowable electric power is calculated by distinguishing the allowable electric power for the electric charging and the allowable electric power for the electric discharge.

Furthermore, as an example of the battery information other than the SOC which is monitored by the controller, there is data indicating instability of the batteries. Regarding the instability of the batteries in the battery system, hunting of the voltage caused by the electric charging/discharging is exemplified. On the other hand, with the vehicle system, a maximum working voltage and a minimum working voltage are set as a specified battery use range. Incidentally, the minimum working voltage is often higher than the overdischarge voltage. Even the voltage is within this battery use range, the hunting is the situation which should be avoided, and this is the object of the present invention.

The battery control method according to embodiments of the present invention (hereinafter also referred to as "this method") can be summarized as follows. Incidentally, voltage values, limitation rates, time, and so on indicated in parentheses are just examples.

[1] This method is a battery control method performed in a battery system (this system) 100, which has a control unit 121 that controls a battery/batteries, a storage unit 180 that stores data regarding allowable electric power for charging the battery, and a measurement unit 120 that measures a voltage value between a pair of electrode terminals of the battery, to appropriately limit the allowable electric power for charging (allowable electric charging power).

The allowable electric power is defined as chargeable maximum electric power which is calculated based on a predetermined upper limit voltage value (in a case of an upper limit voltage = an OCV true value, a voltage threshold value which makes the allowable electric power 0W) and a current charged state. The data includes the following first voltage value Vth1 to third voltage value Vth3.

- The first voltage value Vth1 is a limitation cancellation voltage value (4.2V) and is an upper limit value for which the limitation of the allowable electric power (the limitation rate: 0%) is not required.
- The second voltage value Vth2 is a limitation start voltage value (4.3V), is higher than the first voltage value, and requires the partial limitation of the allowable electric power (the limitation rate: 1% to 99%).
- The third voltage value Vth3 is a limitation end voltage value (4.35V), is higher than the second voltage value, and requires the complete limitation of the allowable electric power (the limitation rate: 100%).

The control unit 121 acquires the voltage value from the measurement unit 120 at every specified time and limits the allowable electric power for charging as follows.

- When the voltage value of the allowable electric power becomes equal to or higher than the third voltage value Vth3, the control unit 121 performs the complete limitation of the allowable electric power (the limitation rate: 100%).
- While the voltage value of the allowable electric power decreases to the second voltage value Vth2 and then to the first voltage value Vth1, the control unit 121 performs the partial limitation of the allowable electric power (the limitation rate: 1% to 99%) or the complete limitation of the allowable electric power (the limitation rate: 100%).

This method operates at the allowable electric charging power limitation unit 501 and limits the allowable electric charging power according to the voltage. The limitation of the allowable electric charging power continues after the voltage value acquired by the measurement unit 120 exceeds the second voltage threshold value Vth2 for starting the limitation until it becomes equal to or lower than the first voltage threshold value Vth1 for the limitation cancellation. Accordingly, unstable behaviors of the assembled battery 110 can be prevented by maintaining the limited state until the voltage reaches a voltage which will not cause the hunting due to voltage fluctuations.

According to this method, the limitation is started at a voltage higher than a central threshold value and the limitation is canceled at a voltage lower than the voltage at which the limitation is started and which is also lower than the central threshold value. Specifically speaking, a specified width is set with the threshold value as its center and the limited state is switched to a canceled state and vice versa according to changes beyond the specified width in order to cause status changes over the threshold value. Consequently, it is possible to enhance the reliability by eliminating the hunting of the limitation on the allowable electric power and its cancellation.

[2] In [1] above, the control unit 121 performs the control under the following condition.

- When performing the complete limitation of the allowable electric power (the limitation rate: 100%) while the voltage value of the allowable electric power decreases from a specified voltage value V1 (4.3V to 4.35V), which is equal to or higher than the second voltage value Vth2 (4.3V) and is equal to or lower than the third voltage value Vth3 (4.35V), to the first voltage value Vth1 (4.2V), the control unit 121 performs control by adding the following condition.
- While the voltage value of the allowable electric power decreases from the first voltage value Vth1 (4.2V) to a fourth voltage value Vth4 (4.1V) which is lower than the first voltage value Vth1 (4.2V) as the above-mentioned condition, the control unit 21 performs the partial limitation of the allowable electric power (the limitation rate: 1% to 99%) based on a specified voltage gradient indicated as voltage fluctuations per unit time.

According to this method, it is possible to provide and control the specified voltage gradient, eliminate shocks by the status changes, further enhance safety, and enhance the reliability of the battery control.

[3] In [1] or [2] above, the control unit 121 performs control under the following conditions by using a voltage value acquired from the measurement unit 120 or an arithmetic operation value obtained by arithmetic processing of the voltage value under a specified condition (a moving average value).

- Within a specified first time period (several tens of seconds),
- if the voltage is equal to or higher than a specified voltage value (4.3V which is the same as the second voltage) which is higher than the first voltage value (4.2V) and lower than the third voltage value (4.35V), and
- if the voltage is equal to or lower than the third voltage value (4.35V) (the moving average voltage is high),

- the control unit 121 relatively decreases the first voltage value (4.2V) (from 4.2V to 4.15V) and updates the first voltage value (4.15V).

According to this method, it is possible to enhance the effect of preventing the hunting of the allowable electric discharge power and expand the electric power use range of the vehicle.

[4] In any one of [1] to [3] above, the control unit 121 performs control under the following conditions by using the voltage value acquired from the measurement unit 120 or the arithmetic operation value obtained by arithmetic processing of the voltage value under a specified condition (the moving average value).

- Within the specified first time period (several tens of seconds),
- if the voltage is equal to or higher than the specified voltage value (4.3V which is the same as the second voltage) which is higher than the first voltage value (4.2V) and lower than the third voltage value (4.35V), and
- if the voltage is not equal to or lower than the third voltage value (4.35V) (the moving average voltage is low),

the control unit 121 relatively increases the first voltage value (4.2V) (from 4.2V to 4.25V) and updates the first voltage value (4.25V).

According to this method, it is possible to further enhance the effect of preventing the hunting of the allowable electric discharge power and expand the electric power use range of the vehicle.

[5] This method is a battery control method for the battery system (this system) 100, which has the control unit 121 that controls a battery/batteries, the storage unit 180 that stores data regarding allowable electric power for discharging the battery, and the measurement unit 120 that measures a voltage value between a pair of electrode terminals of the battery, to appropriately limit the allowable electric power when performing the electric discharge.

The allowable electric power is defined as dischargeable maximum electric power which is calculated based on a predetermined lower limit voltage value (in a case of a lower limit voltage = an OCV true value, a voltage threshold value which makes the allowable electric power 0W) and a current discharged state. The data includes the following first voltage value Vth1 to third voltage value Vth3.

- The first voltage value Vth1 is a limitation cancellation voltage value (3V) and is a lower limit value for which the limitation of the allowable electric power (the limitation rate: 0%) is not required.
- The second voltage value Vth2 is a limitation start voltage value (2.5V), is lower than the first voltage value, and requires a partial limitation of the allowable electric power (the limitation rate: 1% to 99%).
- The third voltage value Vth3 is a limitation end voltage value (2.2V), is higher than the second voltage value, and requires a complete limitation of the allowable electric power (the limitation rate: 100%)

The control unit 121 acquires a voltage value from the measurement unit 120 at every specified time and limits the allowable electric power for electric charging as follows.

- When the voltage value of the allowable electric power becomes equal to or higher than the third voltage value Vth3, the control unit 121 performs the complete limitation of the allowable electric power (the limitation rate: 100%).
- While the voltage value of the allowable electric power decreases to the second voltage value Vth2 and then to the first voltage value Vth1, the control unit 121 performs the partial limitation of the allowable electric power (the limitation rate: 1% to 99%) or the complete limitation of the allowable electric power (the limitation rate: 100%).

This method operates this method operates at the allowable electric discharge power limitation unit 502 and controls the allowable electric discharge power according to the voltage. When the voltage value acquired by the measurement unit 120 becomes lower than the second voltage threshold value Vth2 for the limitation occurrence, the limitation of the allowable electric discharge power continues until the voltage value exceeds the first voltage threshold value Vth1. Consequently, unstable behaviors of the assembled battery 110 can be prevented by maintaining the limited state until the voltage value becomes the voltage which will not cause the hunting due to the voltage fluctuations.

According to this method, if the voltage value becomes lower than the second voltage threshold value Vth2 which is central, the electric discharge limitation is started; and if the returned voltage is higher than that upon the start of the limitation and further exceeds the first voltage value which is higher than the central threshold value, the limitation is cancelled. Specifically speaking, in order to set a specified width with the threshold value as its center and cause status changes beyond the threshold value, the limited state is switched to the canceled state and vice versa as a change occurs beyond the specified width. Consequently, the reliability can be enhanced by eliminating the hunting of the limitation on the allowable electric power and its cancellation.

[6] In [1] above, the control unit 121 performs control under the following condition. - The control unit 121 performs the complete limitation of the allowable electric power (the limitation rate: 100%) while the voltage value of the allowable electric power increase from a specified voltage value V1 (2.2V to 2.5V), which is equal to or lower than the second voltage value Vth2 (2.5V) and is equal to or higher than the third voltage value Vth3 (2.2V), to the first voltage value Vth1 (3V), the control unit 121 performs the control by adding the following condition.

- While the voltage value of the allowable electric power increases from the first voltage value Vth1 (3V) to the fourth voltage value Vth4 (3.1V) which is higher than the first voltage value Vth1 (3V) as the above-mentioned condition, the control unit 121 performs the partial limitation of the allowable electric power (the limitation rate: 1% to 99%) based on a specified voltage gradient indicated as voltage fluctuations per unit time.

According to this method, the specified voltage gradient is provided and controlled to eliminate shocks by the status changes, so that the safety can be further enhanced and the 9reliability of the battery control can be enhanced.

[7] In [5] or [6] above, the control unit 121 performs control under the following conditions by using a voltage value acquired from the measurement unit 120, or an arithmetic operation value obtained by arithmetic processing of the voltage value under a specified condition (a moving average value).

- Within a specified second time period (several tens of seconds),
- if the voltage is equal to or lower than a specified voltage value (2.5V which is the same as the second voltage) which is lower than the first voltage value (3V) and higher than the third voltage value (2.2V), and
- if the voltage is equal to or higher than the third voltage value (2.2V) (when the moving average voltage is low), the control unit 121 relatively increases the first voltage value (3V) (from 3V to 3.1V) and updates the first voltage value (3.1V).

The moving average voltage computing unit 530 illustrated in Fig. 18 calculates the voltage as the moving average voltage in which not only the current voltage, but also the status of a past voltage history is reflected. According to this method, it is possible to enhance the effect of preventing the hunting of the allowable electric discharge power and also expand the electric power use range for the vehicle.

[8] In any one of [5] to [7] above, when the voltage value acquired from the measurement unit 120, or an arithmetic operation value obtained by arithmetic processing of the voltage value under a specified condition (a moving average value)

- within the specified second time period (several tens of seconds)
- is equal to or lower than the specified voltage value (2.5V which is the same as the second voltage) which is lower than the first voltage value (3V) and is higher than the third voltage value (2.2V), and
- is not equal to or higher than the third voltage value (2.2V) (when the moving average voltage is high),
- the control unit 121 relatively decreases the first voltage value (3V) (from 3V to 2.9V) and updates the first voltage value (2.9V).

According to this method, it is possible to further enhance the effect of preventing the hunting of the allowable electric discharge power and expand the electric power use range of the vehicle.

[Supplementary Notes]

Regarding claims, a "battery control apparatus" described in [9] to [12] below may also be possible as subordinate claims of the "battery control method" described in claims 1 to 8. Items [9] and [10] are the "battery control apparatus" corresponding to the requirements of the respective claims 1 and 2. Items [11] and [12] are the "battery control apparatus" corresponding to the requirements of the respective claims 5 and 6.

[9] A battery control apparatus having: a control unit that controls a battery; a storage unit that stores data regarding allowable electric power for charging the battery; and a measurement unit that measures a voltage value between a pair of electrode terminals of the battery, wherein the allowable electric power is defined as chargeable maximum electric power which is calculated based on a predetermined upper limit voltage value and a current charged state; wherein the data includes: a first voltage value that is an upper limit value for which a limitation of the allowable electric power is not required; a second voltage value which is higher than the first voltage value and for which a partial limitation of the allowable electric power is required; and a third voltage value which is higher than the second voltage value and for which a complete limitation of the allowable electric power is required; and wherein the control unit: acquires the voltage value from the measurement unit at every specified time; performs the complete limitation of the allowable electric power when the voltage value of the allowable electric power becomes equal to or higher than the third voltage value; and performs the partial limitation or the complete limitation of the allowable electric power while the voltage value of the allowable electric power decreases to the second voltage value and then to the first voltage value.

[10] The battery control apparatus according to [9] above, wherein when the control unit performs the complete limitation of the allowable electric power while the voltage value of the allowable electric power decreases from a specified voltage value, which is equal to or higher than the second voltage value and is equal to or lower than the third voltage value, to the first voltage value, the control unit performs the partial limitation of the allowable electric power based on a specified voltage gradient represented by voltage fluctuations per unit time while the voltage value of the allowable electric power decreases from the first voltage value to a fourth voltage value which is lower than the first voltage value.

[11] A battery control apparatus having: a control unit that controls a battery; a storage unit that stores data regarding allowable electric power for discharging the battery; and a measurement unit that measures a voltage value between a pair of electrode terminals of the battery, wherein the allowable electric power is defined as dischargeable maximum electric power which is calculated based on a predetermined lower limit voltage value and a current discharged state; wherein the data includes: a first voltage value that is an lower limit value for which a limitation of the allowable electric power is not required; a second voltage value which is lower than the first voltage value and for which a partial limitation of the allowable electric power is required; and a third voltage value which is lower than the second voltage value and for which a complete limitation of the allowable electric power is required; and wherein the control unit: acquires the voltage value from the measurement unit at every specified time; performs the complete limitation of the allowable electric power when the voltage value of the allowable electric power becomes equal to or lower than the third voltage value; and performs the partial limitation or the complete limitation of the allowable electric power while the voltage value of the allowable electric power increases to the second voltage value and then to the first voltage value.

[12] The battery control apparatus according to [11] above, wherein when the control unit performs the complete limitation of the allowable electric power while the voltage value of the allowable electric power increases from a specified voltage value, which is equal to or lower than the second voltage value and is equal to or higher than the third voltage value, to the first voltage value, the control unit performs the partial limitation of the allowable electric power based on a specified voltage gradient represented by voltage fluctuations per unit time while the voltage value of the allowable electric power increases from the first voltage value to a fourth voltage value which is higher than the first voltage value.

REFERENCE SIGNS LIST

| | |
|---|---|
| 100: | battery system (this system) |
| 110: | assembled battery |
| 111: | single batteries |
| 112, 112a, 112b: | single battery groups |
| 120: | measurement unit |
| 121, 121a, 121b: | single battery control units |
| 130: | electric current sensing unit |
| 140: | voltage sensing unit |
| 150: | battery status estimation unit |
| 160: | signal communication unit |
| 170: | insulation element |
| 180: | storage unit |
| 151: | battery status sensing unit |
| 152: | allowable electric power computing unit |
| 153: | allowable electric power calculation unit |
| 154: | allowable electric power limitation unit |
| 200: | vehicle control unit |
| 300,310: | relays |
| 400: | inverter |
| 410: | motor generator |
| 420: | motor/inverter control unit |
| 500: | allowable electric power limitation unit |
| 501: | allowable electric charging power limitation unit |
| 502: | allowable electric discharge power limitation unit |
| 520: | change amount limitation unit |
| 521: | electric charging change amount limitation unit |
| 522: | electric discharge change amount limitation unit |

511, 512:        multiplication units
530:             moving average voltage computing unit

**Claims**

1.  A battery control method using:

    a control unit that controls a battery;
    a storage unit that stores data regarding allowable electric power for charging the battery; and
    a measurement unit that measures a voltage value between a pair of electrode terminals of the battery,
    wherein the allowable electric power is defined as chargeable maximum electric power which is calculated
    based on a predetermined upper limit voltage value and a current charged state;
    wherein the data includes:

    a first voltage value that is an upper limit value for which a limitation of the allowable electric power is not
    required;
    a second voltage value which is higher than the first voltage value and for which a partial limitation of the
    allowable electric power is required; and
    a third voltage value which is higher than the second voltage value and for which a complete limitation of
    the allowable electric power is required; and
    wherein the control unit:

    acquires the voltage value from the measurement unit at every specified time;
    performs the complete limitation of the allowable electric power when the voltage value of the allowable
    electric power becomes equal to or higher than the third voltage value; and
    performs the partial limitation or the complete limitation of the allowable electric power while the voltage
    value of the allowable electric power decreases to the second voltage value and then to the first voltage
    value.

2.  The battery control method according to claim 1,

    wherein when the control unit performs the complete limitation of the allowable electric power while the voltage
    value of the allowable electric power decreases from a specified voltage value, which is equal to or higher than
    the second voltage value and is equal to or lower than the third voltage value, to the first voltage value,
    the control unit performs the partial limitation of the allowable electric power based on a specified voltage gradient
    represented by voltage fluctuations per unit time while the voltage value of the allowable electric power decreases
    from the first voltage value to a fourth voltage value which is lower than the first voltage value.

3.  The battery control method according to claim 1 or 2,

    wherein when the voltage value acquired from the measurement unit or an arithmetic operation value obtained
    by arithmetic processing of the voltage value under a specified condition within a specified first time period is
    equal to or higher than a specified voltage) ,
    which is higher than the first voltage value and is lower than the third voltage value, and is equal to or lower
    than the third voltage value,
    the control unit relatively decreases the first voltage value and updates the first voltage value.

4.  The battery control method according to any one of claims 1 to 3,

    wherein when the voltage value acquired from the measurement unit or an arithmetic operation value obtained
    by arithmetic processing of the voltage value under a specified condition within a specified first time period is
    equal to or higher than a specified voltage, which is higher than the first voltage value and is lower than the
    third voltage value, and is not equal to or lower than the third voltage value,
    the control unit relatively increases the first voltage value and updates the first voltage value.

5.  A battery control method using:

a control unit that controls a battery;
a storage unit that stores data regarding allowable electric power for discharging the battery; and
a measurement unit that measures a voltage value between a pair of electrode terminals of the battery,
wherein the allowable electric power is defined as dischargeable maximum electric power which is calculated
based on a predetermined lower limit voltage value and a current discharged state;
wherein the data includes:

a first voltage value that is a lower limit value for which a limitation of the allowable electric power is not
required;
a second voltage value which is lower than the first voltage value and for which a partial limitation of the
allowable electric power is required; and
a third voltage value which is lower than the second voltage value and for which a complete limitation of
the allowable electric power is required; and
wherein the control unit:

acquires the voltage value from the measurement unit at every specified time;
performs the complete limitation of the allowable electric power when the voltage value of the allowable
electric power becomes equal to or lower than the third voltage value; and
performs the partial limitation or the complete limitation of the allowable electric power while the voltage
value of the allowable electric power increases to the second voltage value and then to the first voltage
value.

6.  The battery control method according to claim 1,

wherein when the control unit performs the complete limitation of the allowable electric power while the voltage
value of the allowable electric power increases from a specified voltage value, which is equal to or lower than
the second voltage value and is equal to or higher than the third voltage value, to the first voltage value,
the control unit performs the partial limitation of the allowable electric power based on a specified voltage gradient
represented by voltage fluctuations per unit time while the voltage value of the allowable electric power increases
from the first voltage value to a fourth voltage value which is higher than the first voltage value.

7.  The battery control method according to claim 5 or 6,

wherein when the voltage value acquired from the measurement unit or an arithmetic operation value obtained
by arithmetic processing of the voltage value under a specified condition within a specified second time period
is equal to or lower than a specified voltage, which is lower than the first voltage value and is higher than the
third voltage value, and is equal to or higher than the third voltage value,
the control unit relatively increases the first voltage value and updates the first voltage value.

8.  The battery control method according to any one of claims 5 to 7,

wherein when the voltage value acquired from the measurement unit or an arithmetic operation value obtained
by arithmetic processing of the voltage value under a specified condition within a specified second time period
is equal to or lower than a specified voltage, which is lower than the first voltage value and is higher than the
third voltage value, and is not equal to or higher than the third voltage value,
the control unit relatively decreases the first voltage value and updates the first voltage value.

FIG. 1

# FIG. 2

Battery Status Estimation Unit — 150

Voltage → Battery Status Sensing Unit — 151

Temperature →

Electric Current →

SOC →

SOHR →

Allowable Electric Power Computing Unit — 152

→ Allowable Electric Charging Power

→ Allowable Electric Discharge Power

180

EP 4 333 253 A1

FIG. 3

Allowable Electric Power Computing Unit — 152

SOC →
SOHR →
Temperature →
Voltage →
Electric Current →

153 — Allowable Electric Power Calculation Unit

Allowable Electric Charging Power after Calculation Unit

Allowable Electric Discharge Power after Calculation Unit

154 — Allowable Electric Power Limitation Unit

→ Allowable Electric Charging Power

→ Allowable Electric Discharge Power

EP 4 333 253 A1

# FIG. 4

## FIG. 5

154

Allowable Electric Power Limitation Unit

Allowable Electric Charging Power after Calculation Unit

Allowable Electric Discharge Power after Calculation Unit

511

512

520

521 — Electric Charging Change Amount Limitation Unit

522 — Electric Discharge Change Amount Limitation Unit

Allowable Electric Charging Power

Allowable Electric Discharge Power

500

SOC

Temperature

Voltage

Electric Current

501 — Allowable Electric Charging Power Limitation Unit

Electric Charging Limitation Rate

502 — Allowable Electric Discharge Power Limitation Unit

Electric Discharge Limitation Rate

# FIG. 6

Movements of limitation rate when voltage reaches Vth1 or higher
(Limitation Occurrence Direction)

FIG. 7

EP 4 333 253 A1

# FIG. 8

Movements of limitation rate when voltage reaches Vth1 or higher
(Limitation Occurrence Direction)

FIG. 9

FIG. 10

# FIG. 11

$$\text{START}$$

$$D_{vol\_chg} = 100(\%) \quad 602$$

$$V \geqq Vth2 ? \quad 601 \quad \text{NO}$$

YES

$$D_{vol\_chg\_z} = 100(\%) \quad 603$$

$$D_{vol\_chg\_now} = \text{Limitation Rate slope(V)} \quad 604$$

$$D_{vol\_chg} = \min(D_{vol\_chg\_now} , D_{vol\_chg\_z}) \quad 605$$

$$D_{vol\_chg\_z} = D_{vol\_chg} \quad 606$$

$$V \leqq Vth1 ? \quad 607 \quad \text{NO}$$

YES

$$D_{vol\_chg} = 100(\%) \quad 608$$

$$\text{END}$$

FIG. 12

FIG. 13

# FIG. 14

START

702

$$D_{vol\_chg} = 100(\%)$$

701

V $\leqq$ Vth2 ?  NO

YES  703

$$D_{vol\_dis\_z} = 100(\%)$$

704

$$D_{vol\_dis\_now} = \text{Limitation Rate slope}(V)$$

705

$$D_{vol\_dis} = \min(D_{vol\_dis\_now}, D_{vol\_dis\_z})$$

706

$$D_{vol\_dis\_z} = D_{vol\_dis}$$

707

NO  V $\geqq$ Vth1 ?

YES  708

$$D_{vol\_dis} = 100(\%)$$

END

FIG. 15

FIG. 16

FIG. 17

## FIG. 18

EP 4 333 253 A1

# FIG. 19

# FIG. 20

## INTERNATIONAL SEARCH REPORT

International application No.

**PCT/JP2022/016965**

### A. CLASSIFICATION OF SUBJECT MATTER

*H02J 7/10*(2006.01)i; *H01M 10/48*(2006.01)i
FI:   H02J7/10 B; H01M10/48 P

According to International Patent Classification (IPC) or to both national classification and IPC

### B. FIELDS SEARCHED

Minimum documentation searched (classification system followed by classification symbols)

H02J7/10; H01M10/48

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 2020-171143 A (DENSO CORP) 15 October 2020 (2020-10-15)<br>entire text, all drawings | 1-8 |
| A | WO 2010/052766 A1 (TOYOTA MOTOR CO LTD) 14 May 2010 (2010-05-14)<br>entire text, all drawings | 1-8 |
| A | JP 2018-98899 A (TOYOTA MOTOR CO LTD) 21 June 2018 (2018-06-21)<br>paragraphs [0072]-[0073], fig. 12 | 1-8 |

☐ Further documents are listed in the continuation of Box C.      ☑ See patent family annex.

| | |
|---|---|
| *    Special categories of cited documents: | "T"    later document published after the international filing date or priority date and not in conflict with the application but cited to understand the principle or theory underlying the invention |
| "A"    document defining the general state of the art which is not considered to be of particular relevance | |
| "E"    earlier application or patent but published on or after the international filing date | "X"    document of particular relevance; the claimed invention cannot be considered novel or cannot be considered to involve an inventive step when the document is taken alone |
| "L"    document which may throw doubts on priority claim(s) or which is cited to establish the publication date of another citation or other special reason (as specified) | "Y"    document of particular relevance; the claimed invention cannot be considered to involve an inventive step when the document is combined with one or more other such documents, such combination being obvious to a person skilled in the art |
| "O"    document referring to an oral disclosure, use, exhibition or other means | |
| "P"    document published prior to the international filing date but later than the priority date claimed | "&"    document member of the same patent family |

| Date of the actual completion of the international search | Date of mailing of the international search report |
|---|---|
| **24 May 2022** | **07 June 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2022/016965**

| Patent document cited in search report | | | Publication date (day/month/year) | Patent family member(s) | | | Publication date (day/month/year) |
|---|---|---|---|---|---|---|---|
| JP | 2020-171143 | A | 15 October 2020 | WO entire text, all drawings | 2020/203454 | A1 | |
| WO | 2010/052766 | A1 | 14 May 2010 | US entire text, all drawings | 2011/0213524 | A1 | |
| | | | | EP | 2363329 | A1 | |
| | | | | CN | 102202947 | A | |
| JP | 2018-98899 | A | 21 June 2018 | (Family: none) | | | |

Form PCT/ISA/210 (patent family annex) (January 2015)

48

**REFERENCES CITED IN THE DESCRIPTION**

**Patent documents cited in the description**

- WO 2012157065 A